# EUROPEAN PATENT APPLICATION

(11) **EP 2 584 621 A1**
(43) Date of publication of application: **24.04.2013**
(21) Application number: 11795716.7
(22) Date of filing: 13.06.2011
(51) Int. Cl.: H01L 33/62

(54) **LEADFRAME FOR OPTICAL SEMICONDUCTOR DEVICE, METHOD FOR MANUFACTURING LEADFRAME FOR OPTICAL SEMICONDUCTOR DEVICE, AND OPTICAL SEMICONDUCTOR DEVICE**

(30) Priority: 09.07.2010 JP 2010157132; 23.06.2010 JP 2010142664; 15.06.2010 JP 2010136596
(71) Applicant: Furukawa Electric Co., Ltd., Chiyoda-ku Tokyo 100-8322 (JP)
(72) Inventor: KOBAYASHI, Yoshiaki, Tokyo 100-8322 (JP); MATSUDA, Akira, Tokyo 100-8322 (JP); SUZUKI, Satoshi, Tokyo 100-8322 (JP); KIKUCHI, Shin, Tokyo 100-8322 (JP); TACHIBANA, Akira, Tokyo 100-8322 (JP); ZAMA, Satoru, Tokyo 100-8322 (JP)
(74) Representative: Forstmeyer, Dietmar
(86) International application number: PCT/JP2011/063542
(87) International publication number: WO 2011/158811

(57) **Abstract**

A lead frame for an optical semiconductor device, having a reflection layer at least on one side or each side of the outermost surface of a substrate, partially or entirely, in which the reflection layer has, on the outermost surface at least in a region where light emitted by an optical semiconductor element is reflected, a microstructure with at least the surface thereof having been mechanically deformed, which is converted from a plating microstructure formed of a metal or an alloy thereof; a method of producing the same, and an optical semiconductor device having the same.

## Description

### TECHNICAL FIELD

The present invention relates to a lead frame for an optical semiconductor device, a method of producing the same, and an optical semiconductor device.

### BACKGROUND ART

Lead frames for optical semiconductor devices have been widely used in, for example, constitution parts of light sources for various display and lighting, in which light-emitting elements of optical semiconductor elements, such as LEDs (light-emitting diodes), are utilized as the light sources. Such an optical semiconductor device is produced by, for example, arranging a lead frame on a substrate, mounting a light-emitting device on the lead frame, and sealing the light-emitting device and its surrounding with a resin or a ceramic, to prevent deterioration of the light-emitting device and its surrounded region by external factors, such as heat, humidity, and oxidization.
In the case of an LED using a lead frame, a material, such as a copper strip, is worked into a punched shape by pressing or etching, followed by plating of Ag, Au/Pd, or the like, to be put to use.

When a LED is used as a light source for lighting, there is a demand for reflective materials for lead frames to have a high reflectance (for example, reflectance against a reference substance, such as barium sulfate or aluminum oxide, of 80% or more) in the whole regions of visible light wavelength (400 to 800 nm).
Further, in recent years, the range of applications of LED that emits ultraviolet radiation (including near-ultraviolet) is expanding, and optical semiconductor devices using LEDs are now also used, for example, in the light sources of measuring/analytic equipments which use ultraviolet radiation, in the light sources of air cleaning apparatuses based on photocatalytic action, in the light sources of ultraviolet sensors, in the light sources for curing of ultraviolet-curable resins. There is a demand for the reflective materials of optical semiconductor devices to have a high reflectance in a near-ultraviolet region (wavelength of 340 to 400nm).
Further, even with regard to LEDs for lighting using white light or LEDs for use in backlight, from the viewpoint of the color rendering property, techniques are being developed, of using violet-color, near-ultraviolet, and ultraviolet LED chips and R, G, and B fluorescent phosphors (luminescent materials) (red, green, and blue), instead of the combination of a blue-color LED chip and a yellow fluorescent phosphor, which has been used hitherto. In these techniques, materials having high reflectance in the near-ultraviolet region (wavelength: 340 nm to 400 nm) and visible light wavelengths (400 nm to 800 nm) are required as the reflective materials for optical semiconductor devices.

The methods of realizing an LED for emitting white light are classified mainly into three kinds: a method of arranging three chips for emitting all lights of red (R), green (G), and blue (B) colors; a method of using a sealing resin prepared by dispersing a yellow fluorescent phosphor in a blue-color LED chip; and a method of using a sealing resin prepared by dispersing R, G, and B fluorescent phosphors in an LED chip that emits light having a wavelength in the ultraviolet to near-ultraviolet region. Conventionally, the method of using a sealing resin prepared by dispersing a yellow fluorescent phosphor in a blue-color chip has been mainly utilized. From the viewpoint that in this method, particularly the color rendering property of red color systems is insufficient, a technique of using an LED chip which includes the ultraviolet region in the emission wavelength band is attracting attention in recent years. For example, a technique is under consideration, of using an LED emitting light with a wavelength near 375 nm, and incorporating R, G, and B fluorescent phosphors into a sealing resin, and thereby emitting white light.

Further, it is requested to suppress corrosion, such as oxidation of lead frame materials, by enhancing the adhesiveness to sealing materials. When the reflectance of a lead frame material deteriorates as a result of the change with the lapse of time, the luminance of the LED is lowered conspicuously. Since this is directly relevant to the service life of LEDs, there is an ongoing investigation on a lead frame material having excellent adhesiveness to sealing materials.

In order to prevent a lead frame material from undergoing deterioration of reflectance due to the change with the lapse of time, a method may be taken, by alloying a metal high in reflectance and a metal excellent in weather resistance; however, a lowering of the reflectance cannot be avoided. Particularly, in metals intrinsically high in reflectance, such as silver and aluminum, the lowering in reflectance due to alloying is conspicuous. Thus, a method is under consideration, for suppressing deterioration of reflectance caused by the change with the lapse of time in a lead frame material, by enhancing the adhesiveness between the lead frame material and a sealing material, while lowering the gas permeability of the sealing material.

In order to cope with such a demand, for the purpose of improvement in light reflectance (hereinafter referred to as reflectance), particularly in a visible light region, in many cases, a layer (coating) composed of silver or a silver alloy is formed on the lead frame on which an LED is mounted. The silver coating is known for its high reflectance in a visible light region. Specifically, known techniques include: forming a silver-plating layer on a reflection plane (Patent Literature 1); and forming a silver or silver alloy layer, followed by subjecting the layer to a heat treatment at 200°C or higher for 30 sec or longer, to give a grain size in the resultant layer of 0.5 to 30 µm (Patent Literature 2). Further, there is known an electrical contact material for spring applications, which is produced by rolling after silver plating, followed by a heat treatment, and it is known that as rolling is carried out, the bonding force among the plating grains is enhanced, and wear resistance is enhanced (Patent Literature 3). It is also known that, in Ag alloy reflection coatings for reflectors and Ag alloy sputtering targets for forming the coatings, the surface roughness Ra of the silver alloy reflection coating is set to 2.0 nm or less (Patent Literature 4).

### CITATION LIST

### PATENT LITERATURES

Patent Literature 1: JP-A-61-148883 ("JP-A" means unexamined published Japanese patent application)
Patent Literature 2: JP-A-2008-016674
Patent Literature 3: Japanese Patent No. 3515226
Patent Literature 4: JP-A-2005-29849

### SUMMARY OF INVENTION

### TECHNICAL PROBLEM

However, it is found that when a coating of silver or its alloy is simply formed, as in Patent Literature 1, a lowering in reflectance is conspicuously, particularly in the near-ultraviolet region (wavelength 340 to 400 nm), and a lowering in reflectance is unavoidable on the shorter wavelength side from the vicinity of about 400 nm (near 300 nm to 400 nm) in the visible light region.

Further, as in Patent Literature 2, when the grain size of a coating of silver or a silver alloy at the surface of a base material with surface roughness 0.5 µm or more is set to 0.5 µm to 30 µm, the reflectance in the visible light region is satisfactory, and an overall reflectance improving effect is acknowledged. However, as shown in Conventional Example of Fig. 8 of this application, and in Fig. 8 and Fig. 9 of Patent Literature 2, an absorption peak is observed in the near-ultraviolet region (340 nm to 400 nm), and particularly near 345 nm to 355 nm, and it can be seen that when an LED chip emitting light of emission wavelength 375 nm is used, the emission wavelength corresponds to a region of lower in reflectance than the visible light region. At that time, when a comparison is made with the case of mounting, for example, a blue-color LED chip emitting light with emission wavelength 450 nm, it is found that the reflectance is lower by about 10%, as compared with the case of using an LED chip emitting light with emission wavelength 375 nm. The details of the appearance of this absorption peak are not clearly understood, but the above are the results which imply that the reflectance in the near-ultraviolet region, particularly near 345 nm to 355 nm, is not easily improved only by simply setting the grain size, and characteristics other than the grain size contribute to an improvement of reflectance.

Further, the absorption peak in the near-ultraviolet region (340 nm to 400 nm), particularly near 345 nm to 355 nm, also affects the reflectance in the visible light region (near 400 nm to near 800 nm), and is also related to lowering in the reflectance for the entire visible light region. This problem becomes serious particularly for wavelengths close to the near-ultraviolet region.
The light emission efficiency of LEDs is being improved every year, but the efficiency is still about 20%. Thus, a reflectance that is lower by 10% means conspicuous lowering in luminance. For this reason, in the case of using a chip emitting light with a wavelength of 340 nm to 400 nm, which is in the near-ultraviolet region, an improvement of reflectance over this wavelength range is needed. By improving the reflectance of the lead frame material, the luminance obtainable per single LED can be enhanced. Thus, many advantages can be expected, such as saving of electric power due to enhancement in the reflection efficiency, and lowering in the number of LEDs to be used in an illumination area.
If the adhesiveness between a lead frame and a sealing material is poor, gas penetrates through a detached or peeled-off area thus occurred, and the surface of the resultant lead frame made of silver or the like undergoes discoloration, causing lowering in reflectance. Thus, there is a demand for a lead frame having improved adhesiveness to sealing materials.
Further, Patent Literature 4 is to improve reflectance over a wavelength range of 400 nm to 450 nm, by setting the surface roughness of a silver alloy reflection coating to 2.0 nm or less. However, Patent Literature 4 has no description in relation to the absorption peak in the near-ultraviolet region. Also, deterioration upon heating is suppressed by alloying, but the technique in Patent Literature 4 does not accomplish enhancement of the adhesiveness to sealing materials, which is necessary for the silver alloy reflection coating to be used in a lead frame material.
Alloying, the grain size, and the like, of the reflection coating of a lead frame material cannot make the reflectance sufficiently satisfactory and cannot solve the problems. The emission efficiency of LEDs is being improved every year, but is still about 20%. Thus, a reflectance that is lower by 10% means a conspicuous lowering in luminance. An improvement of the reflectance from the near-ultraviolet region to the visible light region (340 nm to 800 nm) is required. Further, the problem of insufficient adhesiveness to sealing materials cannot be solved, only by making the reflection coating flat and smooth. In order to maintain high reflectance for a long time period, it is necessary to improve the adhesiveness between a lead frame material and a sealing material.

The inventors of the present invention, having studied keenly, found that grain boundaries formed by plating cause the formation of the absorption peak of the said wavelength region. An attempt was made to extinguish the absorption peak, by reducing these grain boundaries or by narrowing the gaps among the grain boundaries, to prevent light from being absorbed.
In order to address this problem, Patent Literature 2 employs a technique of coarsening the grains of plated silver through a heat treatment after plating, reducing the gap between one grain and another grain, and consequently enhancing the reflectance. However, even if the grains are coarsened by a heat treatment, for example, when a region in which three or more grains are present neighboring is considered, it cannot be necessarily seen that the gaps among those grains are completely extinguished, or the gaps are made narrow. For this reason, it is presumed that when such a heat-treated material is used and made into a product, the heat generated along with light emission of a light emitting element causes contact of the substrate or the under-plating layer, which are underlying materials, with the external air, through the gaps among the grains of the plated silver, to cause oxidation of the substrate or the underlying plating layer, and oxidation of the plated silver is accelerated, causing peeling of the plating. Further, it is also presumed that when coarsening of the grains occurs on the surface side, the roughness at the surface is enlarged, and the reflectance may be deteriorated under the affection of the thus-enlarged surface roughness.
There is also a technique of using a leveler (a leveling agent or a smoothening agent), as a plating for smoothening of the surface. However, in order to smoothen the plating surface without being affected by the surface roughness of the underlying material, a certain extent of plating thickness is needed, and, for example, in the case of providing a smooth plating on the surface of a underlying material with surface roughness 0.5 µm or more, if the plating thickness is, for example, 10 µm or more, surface roughness at a smooth plating surface may be obtained without being affected by the surface roughness of the underlying material. As such, since the plating thickness is increased, it is presumed that there is room for further improvement as a means for improving the reflectance. Moreover, when smoothening is attempted by using a leveling agent, the surface thus obtained does not satisfy the reflectance, wire bonding property, adhesiveness to resins, and the like, required in lead frames. Thus, improvement is also needed in this regard.

Further, Patent Literature 3 discloses no findings in relation to the optical characteristics, such as reflectance, and the rolling is not intended for the purpose of improving the reflectance. Also, since low temperature annealing (heating treatment) for imparting characteristics as an electric contact material is carried out after the rolling, it is found that this heating causes the components of the substrate to diffuse even to the surface layer and causes lowering in the reflectance. In this regard, it is presumed that in the case of the usual applications of electric contact materials, even if certain surface diffusion has occurred, new surfaces are exposed due to sliding, and satisfactory conduction may be obtained, so that the contact characteristics are maintained. However, when it is intended to apply this technique to an optical semiconductor device, since the outermost surface state contributes the most to the optical reflection phenomenon, the reflectance is eventually lowered. From this, it is revealed that simply performing rolling after plating, followed by annealing, cannot easily be applied to a material for use in lead frames for optical semiconductor devices.

The emission efficiency of an LED module is affected by the emission efficiency of the LED chip, as well as by the reflectance of the lead frame surface. If the reflectance of the lead frame surface is low, not only the emission efficiency of the LED module lowers, but also heat generation at the lead frame surface increases, causing shortening of the service life of the LED module, for example, by deterioration of the sealing resin.
For this reason, in the case of realizing an LED module high in color rendering property, which uses an LED chip that emits ultraviolet light, there is a very strong demand for improvement in the reflectance of the lead frame in the near-ultraviolet region at wavelength 340 nm to 400 nm.

Currently, the emission wavelength of the optical semiconductor chip mounted in white-color LED modules is still manly near 450 nm. Thus, an increase in the reflectance in the visible light region is very effective for increase in the luminance of LED modules, and there is a demand for allowing the reflectance to limitlessly approach the theoretical value of the reflectance of silver coatings (reflectance of about 98% at 450 nm), but there is still room for improvement. Further, even in the case of a coating formed of a metal other than silver, or of an alloy of such a metal, there is a demand for achieving the high reflectance in the range from the near-ultraviolet region to the visible light region, which is required in optical semiconductor lead frames.

Thus, the present invention is contemplated for providing a lead frame for an optical semiconductor device, which is used in LEDs, photocouplers, photointerrupters, and the like, having the near-ultraviolet region to visible light region (wavelength 340 nm to 800 nm) included in the emission wavelengths, and which has favorable reflectance, high luminance, and excellent heat dissipation property, when mounted on a chip that emits light in the near-ultraviolet region (wavelength 340 nm to 400 nm), particularly near wavelength 375 nm, and the visible light region (wavelength 400 nm to 800 nm), particularly near wavelength 450 nm; and for providing a method of producing the lead frame. Further, the present invention is contemplated for providing an optical semiconductor device and an illumination device, each of which uses this lead frame.

### SOLUTION TO PROBLEM

In view of the above-described problems of the conventional techniques, the inventors of the present invention, having studied keenly, found that a lead frame for an optical semiconductor device can be obtained, which is excellent in reflectance to light of near-ultraviolet region at wavelength 340 nm to 400 nm, which enables that unnecessary absorption peaks near wavelength 345 nm to 355 nm can be extinguished or drastically suppressed, by providing a reflection layer made of a metal or an alloy thereof, for example, silver or a silver alloy, formed on the outermost surface on a substrate by a plating method, in which after a plating layer is formed as the aforementioned reflection layer, the plating microstructure is squashed by mechanical working, such as rolling, to convert the microstructure to a mechanically deformed metal microstructure. Further, the inventors also found that a lead frame for semiconductor devices excellent in light reflectance can be obtained, in which the reflectance to the visible light region can be increased by several percents (%) as compared with conventional silver plating coatings, and the resultant reflectance can be made close to the theoretical value of silver at the maximum, or alternatively, in which the high reflectance can be achieved from the near-ultraviolet region to the visible light region, which is required in optical semiconductor lead frames, in the case of a coating made of a metal other than silver or an alloy of the metal.

Further, according to the findings of the inventors of the present invention, a conclusion was obtained that the grain boundaries of conventionally utilized silver plating coatings are causative of lowering in the reflectance. It was found that a microstructure obtainable by plating grows, after nucleation in the substrate, respectively in the directions of the length, width and thickness of the nucleus, but the bonding force between silver crystals that are located side by side is weak, and the gaps among the grains are broadened as compared with the grain boundaries of metallurgically produced silver. Further, it was also found that lowering in the reflectance can be suppressed by narrowing these gaps among grain boundaries through mechanical working.

Further, the inventors of the present invention found that in a lead frame for an optical semiconductor device having a reflection layer formed by a plating method at the outermost surface on an electric conductive substrate, the reflectance can be improved, and the adhesiveness to resins can be made high, by controlling the surface shape of the frame macroscopically and microscopically. With regard to the microscopic surface shape, by lowering the surface roughness and setting the surface roughness to a predetermined range, unnecessary absorption peaks in the near-ultraviolet region, particularly near 345 nm to 355 nm, can be extinguished or drastically suppressed, and at the same time, the reflectance in the entire visible light region can also be improved. On the other hand, with regard to the macroscopic surface shape, it was found that, by employing a surface roughness in a certain range, the adhesiveness between the lead frame material and a sealing material (hereinafter, indicated as adhesiveness to resins) is improved. It was found that the reflectance is improved while the adhesiveness to resins is made high, by controlling the smoothness of the surface in terms of two surface roughnesses of macroscopic surface roughness and microscopic surface roughness.
The present invention was achieved based on these findings.

According to the present invention, there is provided the following means:
(1) A lead frame for an optical semiconductor device, having a reflection layer at least on one side or each side of the outermost surface of a substrate, partially or entirely, wherein the reflection layer has, on the outermost surface at least in a region where light emitted by an optical semiconductor element is reflected, a microstructure with at least the surface thereof having been mechanically deformed, which is converted from a plating microstructure formed of a metal or an alloy thereof.
(2) The lead frame for an optical semiconductor device according to item (1), wherein the reflection layer has a surface roughness Ra of 0.010 µm or more measured with a contact needle-type surface roughness meter, and a surface roughness Sa of 50 nm or less measured with an atomic force microscope.
(3) The lead frame for an optical semiconductor device according to item (2), wherein the reflection layer is formed of any one of silver (Ag), gold (Au), copper (Cu), platinum (Pt), aluminum (Al), and rhodium (Rh), or an alloy thereof.
(4) The lead frame for an optical semiconductor device according to item (1), wherein the reflection layer is formed of silver, and at least at a surface thereof, an area ratio of the plating microstructure formed of silver that remains after mechanical deformation is 50% or less.
(5) The lead frame for an optical semiconductor device according to any one of items (1) to (4), wherein a thickness of the reflection layer mechanically deformed is 0.2 µm to 10 µm.
(6) The lead frame for an optical semiconductor device according to item (1) or (5), wherein the metal or the alloy thereof forming the reflection layer is silver, a silver-tin alloy, a silver-indium alloy, a silver-rhodium alloy, a silver-ruthenium alloy, a silver-gold alloy, a silver-palladium alloy, a silver-nickel alloy, a silver-selenium alloy, a silver-antimony alloy, or a silver-platinum alloy.
(7) The lead frame for an optical semiconductor device according to any one of items (1) to (6), wherein the substrate is composed of copper, a copper alloy, iron, an iron alloy, aluminum, or an aluminum alloy.
(8) The lead frame for an optical semiconductor device according to any one of items (1) to (7), wherein the substrate has n layers of metal layers thereon, in which n represents an integer of 1 or more, and wherein the reflection layer is provided on the substrate, directly, or with at least one layer of the metal layer interposed therebetween.
(9) The lead frame for an optical semiconductor device according to any one of items (1) to (8), having a plating layer formed of any one of silver, a silver alloy, tin, a tin alloy, gold, or a gold alloy, at least in an area where soldering is needed.
(10) A method of producing a material of the lead frame for an optical semiconductor device according to any one of items (1) to (8), comprising:
   forming the reflection layer formed of a metal or an alloy thereof, by a plating method, on the outermost surface of the substrate at least in the region where the light emitted by the optical semiconductor element is reflected; and subjecting to mechanical working, to mechanically deform the plating microstructure at least at the surface of the reflection layer.
(11) The method of producing the material of the lead frame for an optical semiconductor device according to item (10), wherein the mechanical working after formation of the reflection layer is carried out, by rolling with a working ratio at the time of rolling being adjusted to from 1% to 80%; or by pressing with a working ratio at the time of pressing being adjusted to from 1% to 80%; or by mechanical polishing.
(12) A method of producing the lead frame for an optical semiconductor device according to any one of items (1) to (8), comprising: forming the reflection layer formed of a metal or an alloy thereof, by a plating method, on the outermost surface of the substrate at least in the region where the light emitted by the optical semiconductor element is reflected; subjecting to mechanical working, to obtain the lead frame material for an optical semiconductor device having the plating microstructure at least at the surface of the reflection layer mechanically deformed; and subjecting the material to punching by a pressing method or an etching method, thereby to obtain the lead frame.
(13) The method of producing the lead frame for an optical semiconductor device according to item (12), wherein the mechanical working after the formation of the reflection layer is carried out, by rolling with a working ratio at the time of rolling being adjusted to from 1% to 80%; or by pressing with a working ratio at the time of pressing being adjusted to from 1% to 80%; or by mechanical polishing.
(14) The method of producing the lead frame for an optical semiconductor device according to item (12) or (13), comprising, after the punching, subjecting to plating to provide, partially thereon, a plating with a satisfactory soldering property.
(15) The method of producing the lead frame for an optical semiconductor device according to item (14), wherein the plating with a satisfactory soldering property is provided at least in a region other than the region where the light emitted by the optical semiconductor element is reflected, and wherein a component of the plating is any one of silver, a silver alloy, tin, a tin alloy, gold, or a gold alloy.
(16) An optical semiconductor device, having: an optical semiconductor element; and the lead frame for an optical semiconductor device according to any one of items (1) to (9), wherein the reflection layer of the lead frame for an optical semiconductor device is provided on the outermost surface of the substrate at least in the region where the light emitted from the optical semiconductor element is reflected, and the plating microstructure at least at the surface has a mechanically deformed microstructure.
(17) The optical semiconductor device according to item (16), wherein an emission wavelength of the optical semiconductor element is from 340 nm to 800 nm.
(18) The optical semiconductor device according to item (16) or (17), wherein the light emitted from the device is white light.
(19) The optical semiconductor device according to item (16) or (17), wherein the light emitted from the device is ultraviolet light, near-ultraviolet light, or violet light.
(20) An illumination device, having the optical semiconductor device according to any one of items (16) to (19).

### ADVANTAGEOUS EFFECTS OF INVENTION

According to the lead frame for an optical semiconductor device of the present invention, by forming the reflection layer formed of a metal or an alloy thereof, for example, silver or a silver alloy, on the outermost surface of a substrate, by a plating method, such as an electroplating method, an electroless plating method, or a sputtering method, and then by subjecting the reflection layer to mechanical working, such as rolling, to mechanically deform at least the surface of the plating microstructure, the unnecessary absorption peaks near wavelength 345 nm to 355 nm can be extinguished or drastically suppressed, the reflection at 340 nm to 400 nm in the near-ultraviolet region is improved, and a satisfactory reflectance is obtained in an optical semiconductor device on which an optical semiconductor chip is mounted, particularly whose emission wavelength includes wavelengths in near-ultraviolet region. Further, according to the same technique, the reflectance at wavelength 400 nm to 800 nm, which is in the visible light region, can be improved to the theoretical value level of silver coating, and in the case of a coating formed of a metal other than silver or an alloy thereof, high reflectance is achieved from the near-ultraviolet region to the visible light region, which is required in optical semiconductor lead frames. Thus, in both cases, satisfactory reflectance is obtained, in an optical semiconductor device on which, for example, a conventional generally-utilized optical semiconductor chip with emission wavelength of near 450 nm is mounted. That is, according to the present invention, a lead frame for an optical semiconductor device can be provided, which has satisfactory reflection characteristics over a wide range from the near-ultraviolet region to the visible light region, and which is more excellent in reflection characteristics than conventional silver-plated materials, particularly when light emitting chips with wavelength 340 nm to 400 nm and further 400 nm to 800 nm in the visible light region in combination use. Further, by using this lead frame for an optical semiconductor device, a high-luminance optical semiconductor device and illumination device can be provided.

Further, according to the lead frame for an optical semiconductor device of the present invention, by forming the reflection layer composed of silver by a plating method on the outermost surface of an electric conductive substrate, followed by subjecting the reflection layer to mechanical working, for example, rolling, so as to cause mechanical deformation at least at the surface of the plating microstructure, and to give the area ratio of a shape similar to the plating microstructure remaining at that surface (hereinafter, referred to as plating microstructure residual ratio) of 50% or less, the reflectance at wavelength 400 nm to 800 nm, which is the visible light region, can be made high to 85% or more, and the reflectance at wavelength 450 nm or more can be made high to 90% or more. Also, an excellent effect is also exhibited in the improvement of the reflectance in the near-ultraviolet region. Further, by using such a lead frame, more excellent heat dissipation property is obtained as compared to the case of forming directly on the circuit of a packaged substrate, and deterioration of the optical semiconductor device due to heat can be delayed.

Further, according to the lead frame for an optical semiconductor device (for example, a component material for LED) of the present invention, the reflectance is excellent in a light region including both the near-ultraviolet region at wavelength 340 nm to 400 nm and the visible light region (near 400 nm to near 800 nm), and high adhesiveness to resins is obtained.

Other and further features and advantages of the invention will appear more fully from the following description, appropriately referring to the accompanying drawings.

### BRIEF DESCRIPTION OF DRAWINGS

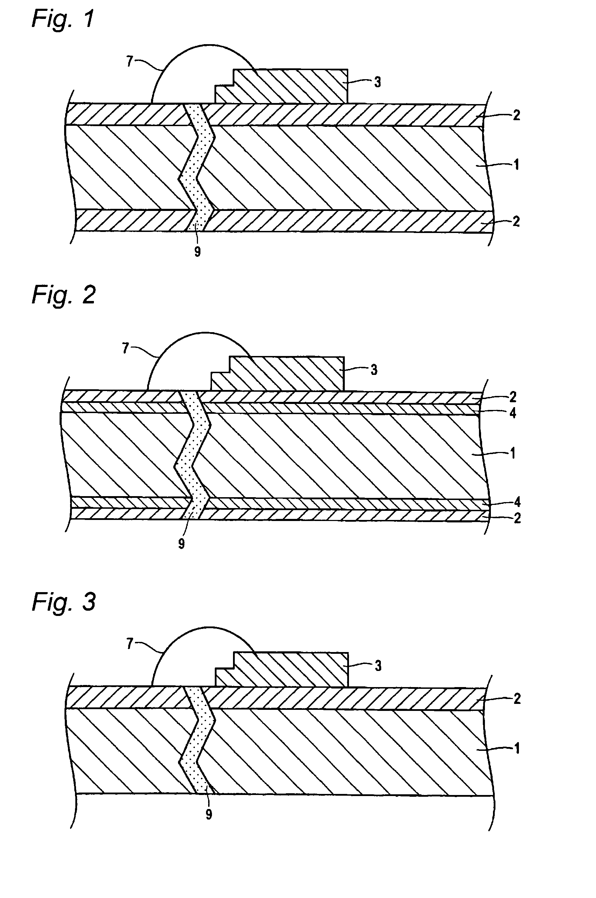

{Fig. 1}
Fig. 1 is a cross-sectional view schematically illustrating a first embodiment of the lead frame for an optical semiconductor device according to the present invention.
{Fig. 2}
Fig. 2 is a cross-sectional view schematically illustrating a second embodiment of the lead frame for an optical semiconductor device according to the present invention.
{Fig. 3}
Fig. 3 is a cross-sectional view schematically illustrating a third embodiment of the lead frame for an optical semiconductor device according to the present invention.
{Fig. 4}
Fig. 4 is a cross-sectional view schematically illustrating a fourth embodiment of the lead frame for an optical semiconductor device according to the present invention.
{Fig. 5}
Fig. 5 is a cross-sectional view schematically illustrating a fifth embodiment of the lead frame for an optical semiconductor device according to the present invention.
{Fig. 6}
Fig. 6 is a cross-sectional view schematically illustrating a sixth embodiment of the lead frame for an optical semiconductor device according to the present invention.
{Fig. 7}
Fig. 7 is a cross-sectional view schematically illustrating a seventh embodiment of the lead frame for an optical semiconductor device according to the present invention.
{Fig. 8}
Fig. 8 is a graph illustrating the reflectance of the lead frame for an optical semiconductor device of Example 19 according to the present invention, together with the reflectance of Conventional Example 1.

### MODE FOR CARRYING OUT THE INVENTION

The lead frame of the present invention has the reflection layer, which is provided, by initially forming a layer of a metal or an alloy thereof, such as silver or a silver alloy, through a plating method, followed by subjecting the layer to mechanical working (for example, plastic working, such as rolling), thereby to cause mechanical deformation by the mechanical working at least at the surface of the metal microstructure (plating microstructure) formed by the plating method. By forming the reflection layer resulting from mechanical deformation of at least the surface of the plating layer, unnecessary absorption peaks at wavelength near 345 nm to 355 nm can be extinguished or drastically suppressed, and the reflectance can be improved. Thus, the lead frame of the present invention is suitably used in an optical semiconductor device to mount thereon a light-emitting chip with emission wavelength region 340 nm to 400 nm, and particularly near 375 nm. Further, the reflectance can also be made high to the theoretical value of Ag, in the visible light wavelength range of 400 nm to 800 nm, and also, in the case of a coating formed of a metal other than silver or an alloy thereof, high reflectance can be achieved from the near-ultraviolet region to the visible light region, which is required in optical semiconductor lead frames.
The plating method may be a wet plating method, such as an electroplating method or an electroless plating method, or alternatively it may be a dry plating method, such as a sputtering method.
Further, the mechanical working may be plastic working, such as rolling or pressing, or alternatively it may be mechanical polishing using colloidal silica or the like. When rolling or pressing is employed, since the entirety of the material including the substrate is subjected to plastic working, the entirety of the plating microstructure is subjected to plastic deformation. On the other hand, when mechanical polishing is employed, the surface of the plating microstructure is smoothened, and at the same time, the surface of the plating microstructure and the surface of the substrate are both subjected to mechanical deformation.

In the present invention, a feature is to have the reflection layer, at the outermost surface, by converting a metal microstructure (plating microstructure) formed by an electroplating method, an electroless plating method, or a sputtering method, as a result of plastic working, such as rolling or pressing, or mechanical polishing, to cause mechanical deformation of at least the surface of the plating microstructure. Herein, the plastically-deformed metal microstructure is different from a cast microstructure, as it has been metallurgically apparent in the technical field of the art, and it is also different from a plating microstructure which is formed by plating before subjected to deformation. Specifically, fine crystals are usually observed at the surface after plating, and needle-shaped microstructure, deposition state of spherical particles, or the like is observed. On the other hand, for example, the surface state obtainable upon rolling or pressing after plating, exhibits a surface state which looks like that the roll marks on the rolling roll or the worked pattern formed on the press molding surface are transferred onto the lead frame. Thus, clear distinction is made possible by, for example, conducting a surface observation with a general-purpose SEM with a magnification of observation of 2,000 to 10,000X. Also, when mechanical polishing is carried out after plating, it can be checked whether the polishing lines of polishing paper or polishing abrasive particles, or a work-affected layer that can be seen by observation of the cross-section, has been formed at the outermost layer, and this can also be clearly distinguished from the state after plating.

Further, according to the lead frame of the present invention, the reflectance can approach limitlessly the physical theoretical value of the reflectance of silver not only in the wavelength range of 340 nm to 400 nm but also in the visible light range of wavelength 400 nm to 800 nm. This reflectance is such that, for example, although the reflectance obtainable when pure silver is formed by a sputtering method on a mirror-surfaced substrate of silicon or the like is about 98% at wavelength 450 nm, the reflectance value is a value which cannot easily achievable only by simple plating, even if a glossing agent is used to a limitless extent. On the other hand, in the case of a coating formed of a metal other than silver or an alloy thereof, high reflectance can be achieved from the near-ultraviolet region to the visible light region, which is required in optical semiconductor lead frames. The inventors of the present invention made it possible to reduce the phenomenon of light absorption to the minimum level, by, after plating, conducting mechanical working, such as rolling, to cause mechanical deformation in the plating microstructure, to squash the plating microstructure, thereby to reduce fine surface unevenness, and to reduce or extinguish the grain boundaries. Thus, the inventors found that the reflectance can be made to approach the theoretical value at the maximum even in the visible light region. As a result, by using the lead frame according to the present invention, excellent luminance is obtained even in a conventional optical semiconductor device emitting light in the visible light region, and the lead frame of the present invention is suitably used in an optical semiconductor device which mounts thereon with a blue-color light-emitting element with emission wavelength region 400 nm to 800 nm, particularly near 450 nm.

Further, it is enough to form the reflection layer in the present invention formed of a metal or an alloy thereof, for example, silver or a silver alloy, at least at the outermost surface of an area which contributes to the reflection of light (that is, at least the region where the light emitted by an optical semiconductor element is reflected). In other areas, it is not necessary to form the reflection layer, and there is no particular problem in terms of reflectance even if a layer other than the reflection layer is formed.

To describe the production method according to the present invention in detail, an electric conductive substrate (for example, a strip) is subjected to a plating method (for example, an electroplating method, an electroless plating method, or a sputtering method), on both sides or on one side, partially or entirely, to form thereon a layer formed of a metal or an alloy thereof, for example, silver or a silver alloy, followed by subjecting to mechanical working, such as rolling, pressing, or mechanical polishing (for example, polishing with colloidal silica), to give the reflection layer. Then, the resultant substrate having the reflection layer is made into the shape of a lead frame, by pressing or an etching method.
On this lead frame, a chip mounting section is formed by resin molding or the like, followed by mounting of an optical semiconductor chip, wire bonding, and sealing with glass or a resin containing fluorescent phosphors, to thereby produce an optical semiconductor module.
In a conventional method, generally, an electric conductive substrate (a strip or the like) is made into the shape of a lead frame by pressing or etching, followed by silver plating or gold/palladium/nickel plating. Further, in the method described in Patent Literature 2, the substrate is subjected to a predetermined heating treatment after plating, so as to coarsen the grain size of the plating layer.
In regard to the present invention and the conventional method, the present invention involves modification of the plating microstructure finished by mechanical working, while the conventional method involves cladding simply finished by working, plating, or heat treatment, or alternatively finished by plating/rolling/heat treatment. Thus, the microstructures are completely different from each other.

Further, it is preferable that the working ratio (or area reduction ratio) at the time of plastic working, such as rolling or pressing, after the formation of the reflection layer, be 1% or more in a portion of the site utilized as the reflection layer. The higher the working ratio is, the more excellent the reflection characteristics are obtained, and a lead frame for LED with higher luminance is obtained. Further, the working ratio at the time of plastic working, such as rolling, after the formation of the reflection layer, is preferably 80% or less, since if the working ratio is higher than 80%, the reflection characteristic enhancing effect is saturated, and also, fracture or cracks are apt to occur upon bending.
The "working ratio" indicates the proportion represented by the formula: "(sheet thickness before working - sheet thickness after working) × 100 / (sheet thickness before working)". Also, regarding the "site utilized as the reflection layer", while an optical semiconductor module is obtained by resin molding for the parts other than the light emitting section at the time of forming an optical semiconductor module, the site utilized as the reflection layer means an area where the light reflection phenomenon occurs, which is a site where the lead frame is exposed when the optical semiconductor chip emits light.

Further, by forming the substrate with copper, a copper alloy, iron, an iron alloy, aluminum, or an aluminum alloy, the lead frame for an optical semiconductor device of the present invention can be made to have a favorable reflectance property, forming of the layers on the surface thereof can be conducted readily, and the lead frame which can contribute to a lowered production cost can be obtained. Further, the lead frame whose substrate is formed with any one of those metals or alloys, is excellent in the heat releasing property (heat dissipation), this is because the generated heat (thermal energy) that is generated upon emission by the light-emitting body can be released or dissipated smoothly to the outside via the lead frame. Based on those, the long service life of the light-emitting element and the long-term stability of the reflectance property can be expected. This is dependant on the electrical conductivity of the substrate, and one with the electrical conductivity of at least 10% or more under IACS (International Annealed Copper Standard) is preferable, and one with the electrical conductivity of 50% or more is more preferable.

Further, by making the thickness of the reflection layer to 0.2 µm or more, which is made of a metal or an alloy thereof, for example, silver or a silver alloy, and which is obtained upon mechanical working, such as rolling, the lead frame for an optical semiconductor device of the present invention can be made to have the reflectance that can be made high stably. Also, this thickness can allow suppression of deterioration due to heating in wire bonding or sealing with a resin or a glass, which are subsequent steps. The upper limit of the thickness of the reflection layer after mechanical working, such as rolling, is preferably set to 10 µm or less, from the viewpoints of reduction of silver that is a noble metal and the plating costs. If the thickness is smaller than the lower limit (for example, 0.1 µm), discoloration due to heating occurs, and also, the proportion of the improvement in reflectance is also small. Thus, in order to more stably prevent discoloration due to heating, the thickness of the reflection layer after mechanical working, such as rolling, is preferably 0.5 µm or more.

When the silver or silver alloy for forming the reflection layer in the lead frame for an optical semiconductor device of the present invention is composed of a material selected from the group consisting of silver, a silver-tin alloy, a silver-indium alloy, a silver-rhodium alloy, a silver-ruthenium alloy, a silver-gold alloy, a silver-palladium alloy, a silver-nickel alloy, a silver-selenium alloy, a silver-antimony alloy, and a silver-platinum alloy, the lead frame with favorable reflectance and productivity is obtained. Particularly, silver, a silver-tin alloy, a silver-indium alloy, a silver-palladium alloy, a silver-selenium alloy, or a silver-antimony alloy is more preferred, from the viewpoint of enhancing the reflectance.

Further, the lead frame for an optical semiconductor device of the present invention may be provided with an intermediate layer composed of a metal or alloy selected from the group consisting of nickel, a nickel alloy, cobalt, a cobalt alloy, copper, and a copper alloy, between the substrate and the reflection layer composed of a metal or a metal alloy (for example, silver or a silver alloy). The intermediate layer is preferably formed by, for example, plating.

For example, in the case of using an iron-based substrate, since the thermal conductivity of the material is relatively low, heat dissipation property can be improved without impairing the reflectance, by providing a layer of copper or a copper alloy as the intermediate layer. Further, since the plating layer which is a copper or copper alloy layer also contributes to enhancement of plating adhesiveness, deterioration of adhesiveness due to heat generation occurring when the light emitting element emits light, can be prevented.
In the case of using a substrate of copper or a copper alloy, it is effective to provide a layer of nickel, a nickel alloy, cobalt, or a cobalt alloy as the intermediate layer, to suppress diffusion of the substrate component into the reflection layer due to heat generation when the light emitting element emits light.

Further, for the purpose of preventing sulfide gas or moisture in the external air that permeates the sealing resin, improvement of resins is also underway, and in some cases, glass sealing is also implemented. Thus, the working temperature employed in the sealing with a resin or glass also rises. Also, for example, when incorporated into an optical semiconductor device, such as an LED, the diffusion phenomenon is expected to proceed also by heat generation of the LED chip. To suppress diffusion in the occasion where the lead frame is used in such a process or as a device, it is effective to provide the intermediate layer.
The thickness of such an intermediate layer is not particularly limited in the present invention, but the thickness is preferably within the range of 0.08 to 2.0 µm. The thickness of the intermediate layer is particularly preferably within the range of 0.2 to 2.0 µm.

Further, by producing the material (strip) for a lead frame for an optical semiconductor by setting the working ratio at the time of mechanical working, such as rolling, after the formation of the reflection layer, to 1% or more, as the working ratio based on the sheet thickness immediately after the initial formation of the reflection layer (immediately after plating), a layer formed of a metal or an alloy thereof, such as silver or a silver alloy, having mechanical deformation, such as plastic deformation, at least at the surface, can be obtained. Thus, a lead frame is obtained, which prevents lowering in the reflectance caused by the emergence of a reflectance absorption peak at 340 to 400 nm, and which has the reflectance improved by several percents (%) as compared to a coating of silver or a silver alloy obtained by a plating method even at wavelength 400 to 800 nm, which is in the visible light region. When the working ratio at the time of mechanical working, such as rolling, after the formation of the reflection layer is less than 1%, mechanical deformation, such as plastic deformation, is insufficient, and the effect is small.

Next, the mechanical working will be described based on rolling as a representative example.
Until giving the product sheet thickness of a lead frame for an optical semiconductor from the sheet thickness immediately after the initial formation of the reflection layer (immediately after plating), any number of rollings as plastic working may be carried out. However, because productivity becomes poor when the number of rollings increases, the number of rollings is preferably 3 or fewer times at the most. The working ratio at the time of rolling after the formation of the reflection layer may be enough to be to 1 % or more for the respective rolling. On the other hand, as the total working ratio until the product sheet thickness from the sheet thickness immediately after the initial formation of the reflection layer (immediately after plating), it is preferable to set the total working ratio at the time of rolling after the formation of the reflection layer, to 10% or more, in consideration of the facts that the reflectance is further enhanced and stabilized, that the change in the mechanical properties of the substrate is suppressed, and that the plating microstructure of the reflection layer can be uniformly plastic-worked.

If the working ratio at the time of rolling after the formation of the reflection layer is made too high, an increase in the plating thickness upon initial formation of the reflection layer (upon plating) is accompanied by an increase in the plating costs, and also, burden to the environment is made large. Further, for the reasons including: an increase in the working costs caused by an increase in the number of rollings after the formation of the reflection layer; the reflectance increasing effect being saturated; and fracture or cracks are apt to occur upon bending, it is preferable to set the working ratio at the time of rolling after the formation of the reflection layer to 80% or less in total.
Further, in the case of an optical semiconductor device obtained through a bending step after conducting an optical semiconductor chip to mount thereon, it is more preferable to set the working ratio to 20% to 60% in total in consideration of bending property.

Further, in order to control the required mechanical characteristics, the reflection layer in the lead frame may be tempered by subjecting to a heat treatment (also referred to as tempering or low-temperature annealing) according to a batch-type means or a continuous (running)-type means after mechanical working, such as rolling, and at the same time, the bonding force among the grains at the grain boundaries may be increased to further narrower the grain boundary gaps. However, it is necessary to conduct the heat treatment to an extent that the reflectance is not lowered.
There are no particular limitations on the conditions of the heat treatment that is conducted after the mechanical working, such as rolling, but, for example, it is preferable to conduct the heat treatment at a temperature of 50 to 150°C for 0.08 to 3 hours. A too high temperature of this heat treatment or a too long heat treatment time period may result in excessive thermal history, to lower the reflectance.

The reflection layer at the surface formed of a metal or an alloy thereof, such as silver or a silver alloy, may be formed by plating in a wet manner by an electroplating method or an electroless plating method, as described above, or alternatively it may be formed by plating in a dry manner on the surface of the metal substrate by a sputtering method to cause deposition to occur. Herein, an electroplating method is taken as a representative example, to explain this process, but in the case of an electroless plating method or a sputtering method, a layer formed of a metal or an alloy thereof, such as silver or a silver alloy, can be formed in the same manner as in an electroplating method, respectively, in a usual manner. For example, in the case of an electroless plating method, the layer may be formed by using a commercially available bath (for example, S-DIA Ag40, manufactured by Sasaki Chemical Co., Ltd.) or the like, and also in the case of a sputtering method, the layer can be produced by using a usual apparatus (for example, SX-200, manufactured by Ulvac Technologies, Inc.) or the like.
The thickness of the reflection layer formed of a metal or an alloy thereof, such as silver or a silver alloy, after the mechanical working, such as rolling, is not particularly limited, but it is preferably set to the range of 0.5 to 10 µm. The coating thickness before working (initial thickness) to achieve this thickness after mechanical working is not particularly limited, but it is preferably set to the range of, for example, 1 to 50 µm.
The mechanical working to a material obtained by coating partially or entirely an electric conductive substrate with a metal or an alloy thereof, such as silver or a silver alloy, can be carried out by, for example, rolling by a cold-rolling machine. Examples of the rolling machine include a two-roll machine, a 4-roll machine, a 6-roll machine, a 12-roll machine, and a 20-roll machine, but any of the rolling machines can be used.
By setting the working ratio (area reduction ratio) by rolling or pressing to 1% or more, preferably 10% or more, the gaps among the grain boundaries of silver or the silver alloy can be sufficiently squashed to narrow, thereby to give a plastically-deformed microstructure.
The rolling roll to be used in rolling has preferably the arithmetic mean of the surface roughness (Ra) of less than 0.1 µm, in consideration of enhancing the reflectance on the lead frame side formed by the transfer of roll marks.
Herein, plastic working via cold rolling is described as a representative example of mechanical working, but in the case of pressing (for example, coining) or mechanical polishing (for example, polishing with colloidal silica), plastic working or mechanical surface working can be carried out in the same manner as in the case of cold rolling, respectively, in a usual manner. For example, in the case of pressing, the target plastic deformation can be achieved by setting the working ratio by adjusting the press pressure to 0.1 N/mm² or more. In the case of mechanical polishing, for example, the target surface working can be achieved, by controlling the time period of polishing, in terms of seconds, by dispersing colloidal silica with particle size 10 to 300 nm, to control the degree of working.
In the case of polishing, this degree of working varies depending on the polishing particles and polishing time period for use, but, for example, in the case of polishing with colloidal silica (OP-S suspension, manufactured by Marumoto Struers K.K.), it is preferable to set the polishing time period to 10 to 60 seconds.

Further, in the optical semiconductor device of the present invention, by using the lead frame of the present invention, a target reflectance property can be obtained effectively at low cost, with the lead frame of the present invention having the reflection layer which is provided by plating with a metal or an alloy thereof, such as silver or a silver alloy, at least at a site where the light emitted from an optical semiconductor element is reflected, in which the entire reflection layer has been subjected to plastic deformation by mechanical working, such as rolling, or at least the surface of the reflection layer has been mechanically deformed. This is because the effect of the reflectance property is sufficiently enhanced, by forming the reflection layer formed of silver or a silver alloy only at the mounting section for the optical semiconductor element. In the case where the LED-mounted face is only one side of the lead frame, the optical semiconductor element-mounting face of a material whose each side is plated may be made thicker, while the non-mounting face may be made thinner.

Further, the reflection layer formed of a metal or an alloy thereof, such as silver or a silver alloy, may be formed partially, or may be formed by one-side plating or partial plating, such as stripe plating or spot plating, followed by mechanical working, such as rolling. By producing a lead frame having the reflection layer partially formed, the amount of metal to be used can be reduced in the region where the reflection layer is unnecessary, to allow to give a lead frame which causes less burden to the environment, thereby to allow to obtain an optical semiconductor device which causes less burden to the environment.

Meanwhile, in regard to the soldering to external leads after the formation of an optical semiconductor module, in the case of a material (strip) on which the reflection layer is formed by plating each side of the material with a metal or an alloy thereof, such as silver or a silver alloy, followed by mechanical working, such as rolling, since the material is worked thereafter into a given lead frame shape by press-punching or etching, the substrate is inevitably exposed at the edge faces of the thus-obtained lead frame. If the lead frame after this pressing or etching is stored while the substrate is exposed, there is a risk of corrosion of the substrate component or deterioration of a soldering property to the substrate surface, and it is preferable to take measures according to the circumstances.
For example, when each side (each face) of the substrate is coated with silver or a silver alloy, the exposed area of the substrate is very small relative to the entire surface, and the affection on the soldering property to external leads is hardly recognizable. Further, the exposure of the substrate does not cause any problem even in the case of a small sheet thickness or a broad lead width. However, in the case of a large sheet thickness or a narrow lead width, there may be affections on the soldering to leads, and the reliability of soldering is enhanced, by plating the external leads.
Further, when only one side of the substrate is coated with a metal or an alloy thereof, such as silver or a silver alloy, or when partial plating including the optical semiconductor element-mounting section (for example, plating in a spot form or a stripe form) is carried out, since the exposed area of the substrate at the external lead section is large, it is preferable to provide a plating coating favorable in solder wettability, after pressing or etching.

To plate an external lead, when a material (strip), on which the reflection layer is formed by plating the material with a metal or an alloy thereof, such as silver or a silver alloy, followed by subjecting the resultant material to mechanical working, such as rolling, is pressed, and then a plating coating (a soldering property-improving layer) favorable in solder wettability of silver, tin, gold, or an alloy thereof, is provided to the external lead section where at least soldering is carried out other than the reflection region of the lead frame, solder wettability is improved. Further, even in the case where the heating temperature is high in the course of process following chip mounting, plating after pressing is effective, from the viewpoint of the soldering property of external leads.
In regard to the plating after pressing or etching, a region including at least the region where the light emitted from an optical semiconductor element is reflected may be plated while being masked, and this can be carried out by any of various means, such as tape- or resist-masking, drum-masking, and belt-masking. Further, outer plating may also be carried out after the formation of a module (resin mold) usually used in IC semiconductors.
The thickness of this plating coating favorable in solder wettability to external leads is not particularly limited in the present invention, but it is enough to secure the soldering property and corrosion resistance during storage, and the thickness may be enough to be about 0.1 µm or more. Likewise, the kind of the plating may be any metal species for achieving the purpose, such as silver, tin, gold, or plating of an alloy thereof.

Hereinafter, other preferred embodiments of the present invention will be described. Herein, items that are not particularly stated in the following description are the same as the items described in the above.

### [Embodiment characterized by plating microstructure residual ratio]

One preferred embodiment of the lead frame of the present invention is characterized in that a reflection layer made of silver is formed by an electroplating method, and then the reflection layer is subjected to plastic working, such as rolling or pressing, or mechanical polishing, so that the plating microstructure made of silver undergoes mechanical deformation at least at the surface. By causing mechanical deformation to the plating layer, the bonding force of the grains at grain boundaries formed by plating is strengthened to eliminate dislocations, to have silver be recrystallized due to the energy of plastic working, and to allow the unevenness at the surface be smoothened by a force mechanically acted. As a result, since the reflectance at wavelength 400 to 800 nm can be enhanced, the lead frame is suitably used particularly in an optical semiconductor device on which an optical semiconductor light-emitting chip to emit a light with wavelength 450 nm to 800 nm is mounted. Among optical semiconductor devices, the lead frame exhibits its effect particularly in LED. Further, the lead frame also gives an excellent effect on enhancement of the reflectance in the near-ultraviolet region.
Hereinafter, this embodiment will be described in detail.

Herein, the residual ratio of a plating microstructure that has not been subjected to mechanical working is preferably 50% or less, more preferably 30% or less, of the region of a site utilized as the reflection layer. Herein, the plating microstructure residual ratio, typically, means the area ratio of: [area of pattern similar to the remaining plating microstructure/area of region to be measured] (%), i.e., the ratio of area of a pattern similar to the below-mentioned remaining plating microstructure, in which, when a silver plating layer is formed by an electroplating method, even if a plating microstructure (a needle-like microstructure or a precipitation state of spherical particles) is formed over almost entirely, the resultant plating microstructure is subjected to mechanical working to undergo mechanical deformation to cause a loss of the plating microstructure, but a pattern similar to the plating microstructure pattern remains on the surface thereafter. The lower this proportion is, the more excellent the reflection characteristics are obtained, and the resultant lead frame can be applied for high-luminance LED. Further, as a result of mechanical working, since there are occasions where no plating microstructure or/and no pattern similar thereto does remain at all, the lower limit value of the plating microstructure residual ratio is 0%. In this embodiment, it is preferable that the plating microstructure residual ratio be closer to 0%, and from the viewpoint of enhancement in reflectance, it is most preferable that the plating microstructure residual ratio be 0%. Herein, the "site utilized as the reflection layer" means the site at which the light reflection phenomenon occurs where the lead frame is exposed, when the LED chip emits a light, in which the LED module is formed through resin molding of regions other than the light emitting section at the time of forming the LED module. That is, the plating microstructure residual ratio at the site where the lead frame is exposed, which contributes to the reflection phenomenon, is preferably 50% or less. It is definitely satisfactory that the entire surface has a plating microstructure residual ratio of 50% or less, but, for example, it is also acceptable that plastic working is carried out in a stripe form or a spot form, and the plating microstructure residual ratio at the site is 50% or less, and only that region serves as the site that is utilized as the reflection layer of the LED.

The lead frame for an optical semiconductor device of the present invention can secure long-term reliability, by setting the thickness of the reflection layer formed of silver to 0.2 µm or more after the mechanical deformation. On the other hand, when the thickness is set to 10 µm or less, a cost reduction can be made without using the novel metal more than necessary. This is because the effect of long-term reliability is saturated when the thickness of the reflection layer reaches 10 µm. If the thickness is 0.2 to 10 µm, the effect is sufficiently expected, but the thickness is preferably 0.5 to 7 µm, more preferably 1 to 5 µm. This implies that, if the silver reflection layer coating thickness after mechanical deformation is less than 0.2 µm, the copper component of the substrate is apt to readily diffuse to the surface, thus, it is preferable that an outermost layer coating thickness of at least 0.2 µm or more be formed. In fact, when a reflection layer with thickness that was equal to or larger than the lower limit was produced, and this was compared with a reflection layer with thickness that was smaller than the lower limit, it was confirmed that heat resistance enhanced in the former case.
When the reflection layer is formed from a silver alloy, it may be difficult to secure a reflectance of 90% at wavelength 400 to 800 nm in some cases. Thus, silver is preferred to be used in the reflection layer of this embodiment, and a purity of 99% or more is preferred.

In this embodiment, in the case where the mechanical working in the method of producing the lead frame for a semiconductor device is rolling, the influence of the surface roughness after electroplating is also significant, but it is preferable that the rolling working ratio be, for example, 10% or more, more preferably 40% or more, with respect to the sheet thickness after plating. By producing the lead frame for an optical semiconductor at a working ratio within this range, it is readily and preferable to control the plating microstructure residual ratio to the preferable range. When the rolling working ratio is equal to or more than the lower limit value, the plating microstructure residual ratio is hardly affected by the roughness of the rolling roll, and thus, the plating microstructure residual ratio can be stably set to 50% or less without depending on the roll roughness, to enhance the reflectance sufficiently. The upper limit of the rolling working ratio is not particularly set, but the upper limit needs to be determined, taking adjustments of the strength, hardness, and electrical conductivity that are required for the material in interest into consideration. Further, if the rolling working ratio is high, the electric power needed by the rolling machine becomes large, and not only a burden to the environment may be made high, but also fracture or cracks are apt to occur upon bending. Thus, the upper limit of the rolling working ratio is practically about 80%.
Until giving the product sheet thickness of a lead frame for an optical semiconductor from the sheet thickness after plating, any number of rollings may be carried out. By adjusting the number of rollings to several times, the probability increases that the plating microstructure is brought into contact with the rolling roll; and as a result, the plating microstructure residual ratio becomes to be readily lowered. However, if the number of times increases, productivity is deteriorated. Thus, the number of rollings is preferably 5 or fewer times at the most. The rolling roll to be used in the rolling preferably has the arithmetic mean of the surface roughness (Ra) of less than 0.1 µm, in consideration of enhancing the reflectance on the lead frame side formed through the transfer of roll marks.

In this embodiment, when the mechanical working in the method of producing the lead frame for an optical semiconductor device is pressing, in the same manner as in the above-mentioned rolling, the pressing working ratio is preferably 10% or more, more preferably 40% or more, with respect to the sheet thickness after plating. By producing the lead frame for an optical semiconductor at a working ratio within this range, it is readily and preferable to set the plating microstructure residual ratio to a preferable range. There are no particular limitations on the conditions for pressing, but plastic deformation can be achieved by for example, setting the press pressure to 0.1 N/mm² or more. The upper limit of the pressing working ratio is not particularly set, but the upper limit is practically about 80%.
Further, in order to control the required mechanical characteristics, the lead frame may be produced through a step of tempering, by subjecting to a heat treatment according to a batch-type means or a continuous-type means after rolling or pressing, but it is necessary to conduct the heat treatment to an extent that the reflectance is not lowered. Preferred conditions for this heat treatment are as described above.

### [Embodiment characterized by surface roughness]

Another preferred embodiment of the lead frame of the present invention will be described.

The macroscopic surface roughness in the present invention is the surface roughness obtainable by a measurement distance of a contact-type surface roughness meter. Specifically, small undulations and the like of the substrate itself are expressed as numerical values. The measurement distance is appropriately between several millimeters to several ten millimeters, and from the results of experiments, it was found that a measurement distance of 4 mm expresses the macroscopic surface roughness most effectively, and this is correlated to the adhesiveness to resins. The surface roughness Ra is determined by the method according to JIS B 6010-2001, to measure at 5 points each in two directions of the rolling direction and the perpendicular direction, to determine the average values as the macroscopic surface roughness.
The microscopic surface roughness in the present invention is the surface roughness obtainable from the observed field of view with an atomic force microscope (AFM). This microscopic surface roughness cannot be measured in the macroscopic surface roughness, but greatly affects reflectance. Specifically, the frequency of deposition of a dendritic form of plating finish, or the like, is expressed as this numerical value. It was found that unevenness in the order of several ten nanometers at the surface is a cause of lowering in reflectance. In order to measure this microscopic surface roughness, it is appropriate to measure the surface roughness within a field of view of several micrometers to several ten micrometers by using an AFM, and from the results of experiments, it was found that measurement in a field of view of 6.16 micrometers × 6.16 micrometers expresses the microscopic surface roughness most effectively, and this is correlated to reflectance. The surface roughness Sa is determined, by using an AFM, in a field of view of 6.16 micrometers × 6.16 micrometers. Further, in order to reduce the influence of large surface scratches and rolling lines of the lead frame, measurements were made at any 5 points of a lead frame in interest, to determine the average value as the microscopic surface roughness.
It was found that the lead frame for an optical semiconductor device can be obtained, which is excellent in the reflectance to both a light in the near-ultraviolet region of wavelength 340 nm to 400 nm and a light in the visible light region of near 400 nm to near 800 nm, and which has high adhesiveness to resins, by maximally suppressing the microscopic surface roughness while leaving the macroscopic surface roughness. The present invention was achieved based on these findings.
The surface roughness as the microscopic surface roughness is measured with an AFM, and the height of the surface undulation as the macroscopic surface roughness is measured with a contact needle-type surface roughness meter, respectively.

The macroscopic surface roughness can be determined, by intermediate rolling or final rolling of the substrate. The macroscopic surface roughness can be changed, by changing the conditions in rolling, the nominal count of rolls, or the like.
The microscopic surface roughness can be changed, by subjecting the outermost surface after plating, to a treatment, such as mechanical polishing by using fine particles. For example, in the case of mechanical polishing, the microscopic surface roughness can be changed, by changing the nominal count, polishing time period, or the like. Further, techniques, such as chemical polishing and electrolytic polishing, may also be used as non-contact polishing.
Further, in plastic working, such as rolling, it is also industrially useful to simultaneously control the microscopic surface roughness and the macroscopic surface roughness. For example, the macroscopic surface roughness can be controlled by appropriately setting the rolling conditions, via rolling after the formation of the reflection coating layer on the substrate by plating or the like, while the microscopic surface roughness can be controlled with a smooth roll whose surface roughness is made small.

One feature of this embodiment lies in that it was clarified by our research that factors hitherto believed to contribute to enhancement of reflectance, such as grain size and orientation (for example, Patent Literature 2), are not factors that substantially improve reflectance, and that we found that only the smoothness of the surface has an influence to the reflectance. Based on this, it was clarified by us that even when any kind of plastic working is conducted, attention may be paid simply to the smoothness of the surface only, without taking into consideration of factors such as grain size and orientation.
Further, it was clarified by us that not only the surface be smoothened by paying attention only to the microscopic surface roughness that affects reflectance, but also it be made a point of roughening the macroscopic surface roughness which corresponds to the small undulation of the substrate or the like, thereby to enhance the adhesiveness to resins. By balancing the two kinds of surface roughness, a lead frame can be provided, which is favorable in reflectance from the near-ultraviolet region to the visible light region, and which is high in luminance and excellent in adhesiveness to the sealing material.

To describe another preferred method of the present invention of producing a lead frame for an optical semiconductor device, for example, an electrically conductive material is subjected to metal plating on each side or on one side thereof.
Metal plating is carried out by a method of depositing a metal on the metal material surface by an electroplating method. The metal plating coating is formed from any one of Au, Ag, Cu, Pt, Al, and Rh, or an alloy thereof. The metal plating coating is preferably composed of Ag or an alloy thereof. The metal plating method itself can be carried out in a usual manner.
The plating surface thus obtained is made smooth by polishing with colloidal silica or the like. In addition to this, the means for making the plating surface smooth may be any working, and, for example, it may be plastic working, such as rolling or pressing, as described above. A preferred working ratio in rolling or pressing is the same as described above. In the present invention, the thickness of the metal plating coating itself on a metal substrate can be set by the plating conditions, or a method of applying working thereafter, and after the polishing or plastic working, the thickness is preferably 0.01 to 20 µm, more preferably 0.1 to 10 µm.
There are no particular limitations on the metal substrate, but, for example, copper, a copper-based alloy, iron, or an iron-based alloy is used. This substrate is preferably made into a strip of a copper alloy having an electrical conductivity of 60% IACS or more, from the viewpoint of the heat dissipation property of the lead frame for an optical semiconductor device. As the copper alloy material with electrical conductivity 60% IACS or more, use can be made, for example, of C19400 and C14410, which are alloys listed in CDA, and EFTEC64T (C18045) (trade name) manufactured by Furukawa Electric Co., Ltd.

In the rolling step in the course of producing the metal substrate, first, the macroscopic surface roughness is changed and controlled to a certain extent, by changing the roll roughness for finish rolling that is finally conducted. Since there is a fluctuation to some extent in actual strip products, among the strips produced by changing the conditions, a strip having a desired roughness is selected and subjected to electroplating. When the roll roughness is small, a substrate having small macroscopic surface roughness is obtained, and when the roll roughness is large, a substrate having large macroscopic surface roughness is obtained. The macroscopic surface roughness is measured with a contact needle-type surface roughness meter. The macroscopic surface roughness is preferably Ra of 0.010 µm or more, more preferably 0.020 µm or more, even more preferably 0.030 µm or more, and most preferably 0.040 µm or more. By setting the macroscopic surface roughness in such a range, the adhesiveness to resins is improved. Further, if the macroscopic surface roughness is more than 0.100 µm, the rise and fall (height of undulation) of the substrate surface becomes too big, resulting in that the sealing material does not sufficiently put or penetrate into the valleys of the undulation. This does not cause a substantial lowering in adhesiveness to resins, but because the contact area lowers, consequently, the macroscopic surface roughness is preferably 0.060 µm or less. Herein, the "improvement in adhesiveness to resins" means that no peeling occurs in the resin adhesiveness test, as evaluated in the Example section described below.

In the lead frame for an optical semiconductor device of this embodiment, which is obtainable by depositing a plating coating, on at least one side or on each side, of a metal substrate, partially or entirely, by electrodeposition, such as an electroplating method, or by an electroless plating method or a sputtering method, followed by working the surface of the resultant plating coating, secondly, the microscopic surface roughness is specified. The microscopic surface roughness is obtained by making measurement in an angle of view of 6.16 µm × 6.16 µm with an atomic force microscope. When the microscopic surface roughness Ra is set to preferably 50 nm or less, more preferably 30 nm or less, particularly preferably 10 nm or less, and most preferably 5 nm or less, the reflectance of the part materials for LED is improved. Herein, the "improvement of reflectance" means that a material has the preferred reflectance as described below.
If the microscopic surface roughness is about 2.0 nm or less, the adhesiveness to resins is lowered regardless of the macroscopic surface roughness, and the microscopic surface roughness is preferably 3.0 nm or more.
Since the plating layer is subjected to rolling after formed of a metal, such as Ag, or an alloy thereof, the macroscopic surface roughness and the microscopic surface roughness are simultaneously changed.
Herein, the macroscopic surface roughness and the microscopic surface roughness can be changed, simultaneously, by changing the rolling working ratio. The microscopic surface roughness can be controlled to a certain extent, by changing the roll roughness to be used in rolling. Even at the same rolling working ratio, if the roll roughness is small, the microscopic surface roughness becomes small.
In the present invention, the control of the microscopic surface roughness contributes directly to the reflectance, and as this roughness is smaller, the reflectance (particularly, the reflectance in the ultraviolet region) is improved. Further, the macroscopic surface roughness contributes to improvement of solder wettability and adhesiveness to resins, to impart favorable characteristics to the lead frame for an optical semiconductor device, while maintaining excellent smoothness as well.
In this embodiment, the action/effect of the reflectance can be further improved, by setting both the microscopic surface roughness and the macroscopic surface roughness to values in the preferred ranges, respectively, and combining those two. Such a matter is not relevant to the attention paid to the conventional recrystallized grain size and orientation of the metal as described above.

As a preferred reflectance in the present invention, in the case of silver plating which is a preferred metal plating coating, the following embodiments are preferred. Preferred conditions will be described in the order of the following items (a), (b), (c), and (d). Item (d) is the most preferred conditions.
(a) Silver plating: the total reflectance in the visible light region (for example, 400 to 800 nm) is 80% or more (for a white-color LED which entirely reflects the light), and the total reflectance in the near-ultraviolet region (for example, 375 nm) is 70% or more (for an LED which reflects blue-color wavelength in the ultraviolet light region to white color by means of a yellow-color fluorescent phosphor).
(b) Silver plating: the total reflectance in the visible light region (for example, 400 to 800 nm) is 85% or more, and the total reflectance in the near-ultraviolet region (for example, 375 nm) is 75% or more.
(c) Silver plating: the total reflectance in the visible light region (for example, 400 to 800 nm) is 90% or more, and the total reflectance in the near-ultraviolet region (for example, 375 nm) is 90% or more.
(d) Silver plating: the total reflectance in the visible light region (for example, 400 to 800 nm) is 95% or more, and the total reflectance in the near-ultraviolet region (for example, 375 nm) is 95% or more.
Further, when the metal plating coating is gold, the following embodiment is preferred.
The total reflectance is 30% or more in the entire range of the near-ultraviolet region (for example, 375 nm) and the visible light region (for example, 400 to 800 nm), and particularly, the total reflectance in the longer wavelength side in the visible light region is high.
When the metal plating coating is copper, the following embodiment is preferred.
The total reflectance is 35% or more in the entire range of the near-ultraviolet region (for example, 375 nm) and the visible light region (for example, 400 to 800 nm), and particularly, the total reflectance in the longer wavelength side in the visible light region is high.
Further, when the metal plating coating is platinum, the following embodiment is preferred.
The total reflectance in the visible light region (for example, 400 to 800 nm) is 55% or more, and the total reflectance in the near-ultraviolet region (for example, 375 nm) is 55% or more.
Further, when the metal plating coating is aluminum, the following embodiment is preferred.
The total reflectance in the visible light region (for example, 400 to 800 nm) is 85% or more, and the total reflectance in the near-ultraviolet region (for example, 375 nm) is 95% or more.
When the metal plating coating is rhodium, the following embodiment is preferred.
The total reflectance is 75% or more in the entire range of the near-ultraviolet region (for example, 375 nm) and the visible light region (for example, 400 to 800 nm), and particularly, the total reflectance in the longer wavelength side in the visible light region is high.

Plating with silver or a silver alloy, and plating with a metal other than these can be carried out by a method of causing deposition on the metal material surface by an electroplating method, an electroless plating method, or a sputtering method. The plating coating of silver or a silver alloy is not particularly limited, but use can be made of pure silver, a silver-antimony alloy, a silver-selenium alloy, a silver-indium alloy, a silver-tin alloy, a silver-gold alloy, and the like.
The thickness of the plating is not particularly limited, but after the plastic working, the formation of the plating is generally carried out to a thickness in the range of 0.2 to 10 µm.
A material prepared by coating partially or entirety an electric conductive substrate with silver, a silver alloy, or a metal other than these, is subjected to rolling by means of a cold rolling machine. Examples of the rolling machine include a two-roll machine, a 4-roll machine, a 6-roll machine, a 12-roll machine, and a 20-roll machine, but any of the rolling machines can be used.
By setting the rolling working ratio (also referred to as area reduction ratio, or simply as working ratio) to 1% or more, the distance (gap) between the grain boundaries of silver, a silver alloy or a metal other than these, can be made narrow. A more preferred working ratio is 10% to 50%.
The rolling roll to be used in rolling has preferably the surface roughness Ra of less than 0.1 µm.

Hereinafter, embodiments of the lead frame for an optical semiconductor device of the present invention will be described, using the drawings. Some of the drawings show a state that the optical semiconductor element is mounted on the lead frame. The respective embodiment is an example, and the scope of the present invention is not limited to those embodiments.
Further, the embodiments as shown in the drawings are presented in the maximally schematic and omitted manner as needed for the explanation, and the dimension, and the specific structure of a lead frame or an element are not intended to be construed to be limited to the drawings.

Fig. 1 is a cross-sectional view schematically illustrating the first embodiment of the lead frame for an optical semiconductor device according to the present invention. In the lead frame of this embodiment, a reflection layer 2 composed of silver or a silver alloy is formed on a substrate 1, and an optical semiconductor element 3 is mounted on a portion of the surface of the reflection layer 2. Further, by a bonding wire 7, the optical semiconductor element 3 and the lead frame on the other side that is insulated by a cutaway section 9 (in the figure, represented in a schematic and omitted manner as the region shaped by broken lines) are connected electrically, to form a circuit. According to the present invention, the lead frame of this embodiment is a lead frame for an optical semiconductor device excellent in the reflection characteristics in the near-ultraviolet and visible light region (wavelength 340 m to 800 nm), in which the reflection layer 2, formed by electroplating or the like, is made to have, for example, plastic deformation by rolling.

Fig. 2 is a cross-sectional view schematically illustrating the second embodiment of the lead frame for an optical semiconductor device according to the present invention. A difference between the lead frame of the embodiment shown in Fig. 2 and the lead frame shown in Fig. 1 is that an intermediate layer 4 is formed between the substrate 1 and the respective reflection layer 2. Other points are the same as those of the lead frame shown in Fig. 1.

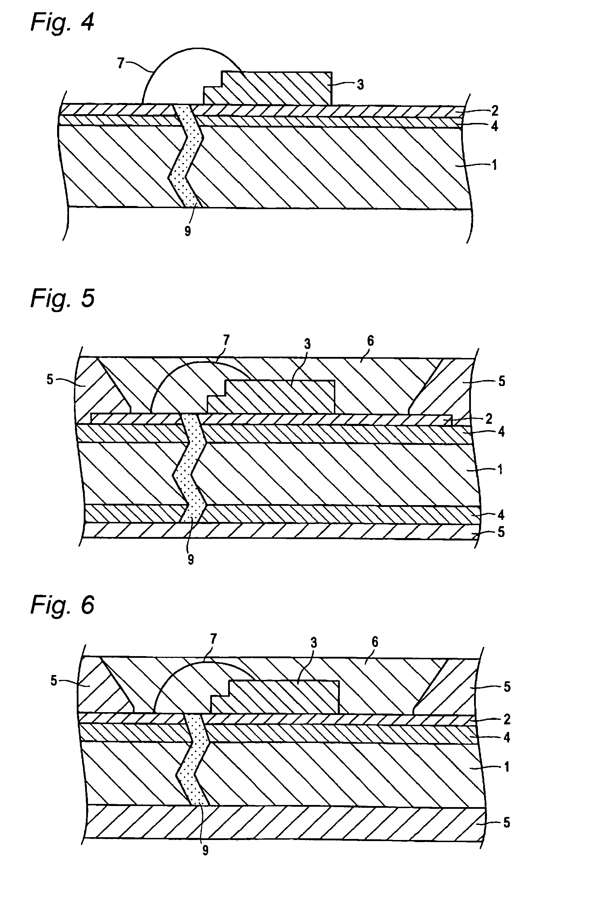

Fig. 3 and Fig. 4 are cross-sectional views schematically illustrating the third embodiment and the fourth embodiment, respectively, in which the reflection layer modified by, for example, rolling or the like after electroplating, is provided only on one side on which the optical semiconductor element is mounted. The difference between Fig. 3 and Fig. 4 is an intermediate layer 4, whether provided (Fig. 4) or not (Fig. 3).

Fig. 5 is a cross-sectional view schematically illustrating the fifth embodiment of the lead frame for an optical semiconductor device according to the present invention. Fig. 5 illustrates, in a convenient manner, the structure, in which an optical semiconductor module is formed with a molding resin 5 and a sealing resin 6, and the reflection layer 2 is formed only in the area on which the optical semiconductor element 3 is mounted, at a site which is close to the area and at which the reflection phenomenon occurs, and at the inner side of the molding resin 5. In this embodiment, the intermediate layer 4 is formed over the entire of the substrate 1, but if the intermediate layer 4 is interposed between the substrate 1 and the reflection layer 2, the intermediate layer 4 may be partially formed. Further, the reflection layer 2 is formed to the middle of the lower part of the molding resin 5, but it is enough if the region which contributes to the reflection phenomenon is covered, or the reflection layer may cover up to the external side of the molding resin 5 or may cover only at the inner side of the molding resin.
In the present invention, as described above, the reflection layer 2 formed of a metal or an alloy thereof, such as silver or a silver alloy, can also be formed only in the area which contributes to light reflection.

Fig. 6 is a cross-sectional view schematically illustrating the sixth embodiment of the lead frame for an optical semiconductor device according to the present invention. Similarly to Fig. 5, Fig. 6 illustrates, in a convenient manner, the structure, in which the optical semiconductor module is formed with the molding resin 5 and the sealing resin 6. The differences between the embodiment of Fig. 6 and that of Fig. 5 are: that the intermediate layer 4 is provided only on the side where the optical semiconductor element 3 for the substrate 1 is disposed; and that the reflection layer 2 is provided over the entire of the substrate 1.

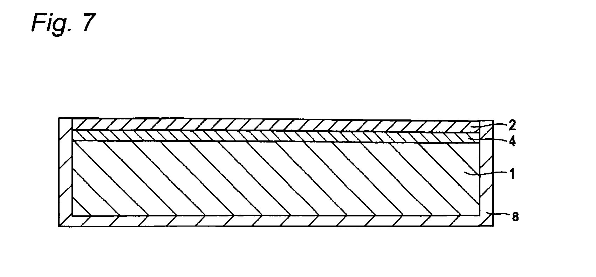

Fig. 7 is a cross-sectional view schematically illustrating the seventh embodiment of the lead frame for an optical semiconductor device according to the present invention. In Fig. 7, in a section for soldering to the outside, a solderability-improving layer 7, formed of a plating favorable in a soldering property (silver or a silver alloy, tin or a tin alloy, gold or a gold alloy), is provided, at the edges due to pressing and the backing side. In Fig. 7, the optical semiconductor element (3) mounted on the lead frame is omitted.
The solderability-improving layer 7 that is provided after the pressing and is formed of a plating of, for example, silver, tin, or gold, secures a more stabilized soldering property. In this case, the solderability-improving layer 7 may also be provided, on the face where the reflection layer is formed, in an area other than the area where the reflectance is required (that is, a region where at least the light emitted by the optical semiconductor element is reflected).

### EXAMPLES

The present invention will be described in more detail based on examples given below, but the invention is not meant to be limited by these.

### (Example 1)

As Example 1, substrates with width 100 mm, as shown in Table 1, were subjected to the respective pretreatment as shown below, followed by electroplating as shown below. Then, on the resultant substrates, reflection layers were initially formed by plating, by changing the sheet thickness upon initial formation of the reflection layer (upon plating), taking into consideration the working ratio at the time of rolling after the formation of the reflection layer, so that the total sheet thickness including the coating thickness after rolling would be 0.2 mm. Then, the thus-plated substrates were subjected to rolling to thickness 0.2 mm at the respective area reduction ratio as shown in Table 1, using a 6-stage rolling machine (manufactured by Hitachi, Ltd.), with rolls in which rolling work rolls had the surface roughness Ra of approximately 0.03 µm, to obtain samples (rolling finished products) of Examples 1 to 38 and Reference Examples 1 to 3, having the structures as shown in Table 1, respectively. Further, Reference Example 4 was a simulation of Comparative Example 1 of Patent Literature 3, and Reference Example 5 was a simulation of Example 2 of Patent Literature 3, respectively, and those samples were provided by rolling, followed by a heat treatment at 240°C for 4 hours (heat treatment finished products). Further, with respect to Conventional Examples 1 to 4, substrates with sheet thickness 0.2 mm and width 100 mm were subjected to the pretreatment as shown below, followed by electroplating to form reflection layers as shown below, to obtain mother materials (strips) for lead frames, as shown in Table 1.
(Conventional Examples 1, 2 and 4 were plating finished products). Further, in regard to Conventional Example 3, in order to reproduce the state of coating, as described in Example 8 of Patent Literature 2, on the substrate according to this Example, a sample was provided, by forming a plating layer under the conditions described in Patent Literature 2, followed by a heat treatment at 320°C for 30 seconds under an atmosphere with residual oxygen concentration 500 ppm (heat treatment finished product). Those of Examples and Comparative Examples, which had no intermediate layer, each correspond to the structure of the lead frame, as shown in Fig. 1, and those of Examples and Reference Examples, which had the intermediate layer, each correspond to the structure of the lead frame, as shown in Fig. 2.
In the evaluation of this Example, no pressing was carried out for convenience, and the samples were evaluated in the strip shape.

Herein, out of materials used as the substrates, "C14410 (Cu-0.15Sn, manufactured by Furukawa Electric Co., Ltd., EFTEC-3)", "C19400 (a Cu-Fe-based alloy material: Cu-2.3Fe-0.03P-0.15Zn)", "C26000 (brass: Cu-30Zn)", "C52100 (phosphor bronze: Cu-8Sn-P)", "C77000 (nickel silver:Cu-18Ni-27Zn)", and "C18045 (Cu-0.3Cr-0.25Sn-0.5Zn, manufactured by Furukawa Electric Co., Ltd., EFTEC-64T)" represent copper or copper alloy substrates, and the alloy number indicates the respective type as stipulated by CDA (Copper Development Association) standards. The unit of the numerical value preceding each element is in terms of mass%.
Further, "A1100", "A2014", "A3003", and "A5052" represent aluminum or aluminum alloy substrates. The alloy compositions thereof are stipulated in Japanese Industrial Standards (e.g., JIS H 4000:2006).
Further, "42 alloy" represents an iron-based substrate of an alloy containing 42 mass% of nickel, with the balance being iron and unavoidable impurities.
When the substrate was aluminum, the pretreatment was carried out via the steps of electrolytic degreasing, acid pickling, and zincate conversion, and in the cases of other substrates, the pretreatment was carried out via the steps of electrolytic degreasing and acid pickling. Further, silver strike plating was conducted before plating of silver or a silver alloy in the respective cases, and the outermost layer plating thickness is shown as the thickness after rolling, including the silver strike plating thickness.

Conditions of the pretreatment employed in Example 1 are shown below.

### (Pretreatment conditions)

### [Cathodic electrolytic degreasing]

Degreasing liquid: NaOH 60 g/L
Degreasing conditions: 2.5 A/dm², temperature 60°C, degreasing time period 60 seconds

### [Acid pickling]

Acid pickle: 10% sulfuric acid
Acid pickling conditions: 30 seconds dipping, room temperature [Zincate conversion] (Conducted when the substrate was of aluminum)
Zincate conversion liquid: NaOH 500 g/L, ZnO 100 g/L, dihydroxysuccinic acid (C₄H₆O₆) 10 g/L, FeCl₂ 2 g/L
Treatment conditions: 30 seconds dipping, room temperature

### [Ag strike plating] Layer thickness 0.01 µm

Plating liquid: KAg(CN)₂ 5 g/L, KCN 60 g/L
Plating conditions: Current density 2 A/dm², plating time period 4 seconds, temperature 25°C

Compositions of plating liquids and plating conditions for the intermediate layer plating employed in Example 1 are shown below.

### (Intermediate layer plating conditions)

### [Ni plating]

Plating liquid: Ni(SO₃NH₂)₂·4H₂O 500 g/L, NiCl₂ 30 g/L, H₃BO₃ 30 g/L
Plating conditions: Current density 5 A/dm², temperature 50°C

### [Co plating]

Plating liquid: Co(SO₃NH₂)₂·4H₂O 500 g/L, CoCl₂ 30 g/L, H₃BO₃ 30 g/L
Plating conditions: Current density 5 A/dm², temperature 50°C

### [Cu plating]

Plating liquid: CuSO₄·5H₂O 250 g/L, H₂SO₄ 50 g/L, NaCl 0.1 g/L
Plating conditions: Current density 6 A/dm², temperature 40°C

Compositions of plating liquids and plating conditions for the reflection layer employed in Example 1 are shown below.

### (Reflection layer plating conditions)

### [Ag plating]

Plating liquid: AgCN 50 g/L, KCN 100 g/L, K₂CO₃ 30 g/L
Plating conditions: Current density 1 A/dm², temperature 30°C

### [Ag-Sn alloy plating]

Plating liquid: KCN 100 g/L, NaOH 50 g/L, AgCN 10 g/L, K₂Sn(OH)₆ 80 g/L
Plating conditions: Current density 1 A/dm², temperature 40°C

### [Ag-In alloy plating]

Plating liquid: KCN 100 g/L, NaOH 50 g/L, AgCN 10 g/L, InCl₃ 20 g/L
Plating conditions: Current density 2 A/dm², temperature 30°C

### [Ag-Pd alloy plating]

Plating liquid: KAg(CN)₂ 20 g/L, PdCl₂ 25 g/L, K₄O₇P₂ 60 g/L, KSCN 150 g/L
Plating conditions: Current density 0.5 A/dm², temperature 40°C

### [Ag-Se alloy plating]

Plating liquid: KCN 150 g/L, K₂CO₃ 15 g/L, KAg(CN)₂ 75 g/L, Na₂O₃Se·5H₂O 5 g/L
Plating conditions: Current density 2 A/dm², temperature 50°C

### [Ag-Sb alloy plating]

Plating liquid: KCN 150 g/L, K₂CO₃ 15 g/L, KAg(CN)₂ 75 g/L, C₄H₄KOSb 10 g/L
Plating conditions: Current density 1 A/dm², temperature 50°C

{Table 1}

**Table 1**

| | Substrate | Intermediate layer | | Outermost layer | | Area reduction ratio | Heat treatment |
|---|---|---|---|---|---|---|---|
| | | Kind | Layer thickness (µm) | Kind | Layer thickness (µm) | | |
| Ex. 1 | C14410 | Ni | 0.08 | Ag | 5 | 43% | None |
| Ex. 2 | C14410 | Ni | 0.08 | Ag | 2 | 43% | None |
| Ex. 3 | C14410 | Ni | 0.08 | Ag | 1 | 43% | None |
| Ex. 4 | C14410 | Ni | 0.08 | Ag | 0.5 | 43% | None |
| Ex. 5 | C14410 | Ni | 0.08 | Ag | 0.2 | 43% | None |
| Ex. 6 | C14410 | None | None | Ag | 10 | 37% | None |
| Ex. 7 | C14410 | None | None | Ag | 5 | 37% | None |
| Ex. 8 | C14410 | None | None | Ag | 2 | 37% | None |
| Ex. 9 | C14410 | None | None | Ag | 1 | 37% | None |
| Ex. 10 | C14410 | None | None | Ag | 0.5 | 37% | None |
| Ex. 11 | C14410 | None | None | Ag | 0.2 | 37% | None |
| Ex.12 | C14410 | Ni | 0.2 | Ag | 2 | 43% | None |
| Ex. 13 | C14410 | Ni | 0.5 | Ag | 2 | 43% | None |
| Ex. 14 | C14410 | Ni | 2 | Ag | 2 | 43% | None |
| Ex. 15 | C14410 | None | None | Ag | 1 | 1% | None |
| Ex. 16 | C14410 | None | None | Ag | 1 | 5% | None |
| Ex. 17 | C14410 | None | None | Ag | 1 | 10% | None |
| Ex. 18 | C14410 | None | None | Ag | 1 | 20% | None |
| Ex. 19 | C14410 | None | None | Ag | 1 | 60% | None |
| Ex. 20 | C14410 | None | None | Ag | 1 | 80% | None |
| Ex. 21 | C14410 | None | None | Ag | 10 | 80% | None |
| Ex. 22 | C14410 | Co | 0.5 | Ag | 2 | 43% | None |
| Ex. 23 | C14410 | Cu | 0.5 | Ag | 2 | 43% | None |
| Ex. 24 | C14410 | Ni | 0.5 | Ag-Sn | 2 | 43% | None |
| Ex. 25 | C14410 | Ni | 0.5 | Ag-In | 2 | 43% | None |
| Ex. 26 | C14410 | Ni | 0.5 | Ag-Pd | 2 | 43% | None |
| Ex. 27 | C14410 | Ni | 0.5 | Ag-Se | 2 | 43% | None |
| Ex. 28 | C14410 | Ni | 0.5 | Ag-Sb | 2 | 43% | None |
| Ex. 29 | C19400 | Ni | 0.5 | Ag | 2 | 43% | None |
| Ex. 30 | C52100 | Ni | 0.5 | Ag | 2 | 43% | None |
| Ex. 31 | C26000 | Ni | 0.5 | Ag | 2 | 43% | None |
| Ex. 32 | C77000 | Ni | 0.5 | Ag | 2 | 43% | None |
| Ex. 33 | C18045 | Ni | 0.5 | Ag | 2 | 43% | None |
| Ex. 34 | 42 alloy | Ni | 0.5 | Ag | 2 | 43% | None |
| Ex. 35 | A1100 | Ni | 0.5 | Ag | 2 | 43% | None |
| Ex. 36 | A2014 | Ni | 0.5 | Ag | 2 | 43% | None |
| Ex. 37 | A3003 | Ni | 0.5 | Ag | 2 | 43% | None |
| Ex. 38 | A5052 | Ni | 0.5 | Ag | 2 | 43% | None |
| Ref. ex. 1 | C14410 | None | None | Ag | 0.1 | 37% | None |
| Ref. ex. 2 | C14410 | None | None | Ag | 2 | 0.5% | None |
| Ref. ex. 3 | C14410 | None | None | Ag | 1 | 85% | None |
| Ref. ex. 4 | C14410 | None | None | Ag | 1 | 40% | 240°C, 4 hr |
| Ref. ex. 5 | C14410 | Cu | 1 | Ag | 1 | 40% | 240°C, 4 hr |
| Conv. ex. 1 | C14410 | Ni | 0.5 | Ag | 2 | None | None |
| Conv. ex. 2 | C14410 | Cu | 1 | Ag | 0.2 | None | None |
| Conv. ex. 3 | C14410 | Cu | 10 | Ag | 2 | None | 320°C, 30 sec |
| Conv. ex. 4 | C14410 | Ni | 0.08 | Ag | 0.2 | None | None |

| | | | | | | | |
|---|---|---|---|---|---|---|---|
| Note: "Ex" means Example according to this invention. (The same is applied herein.) Note: "Ref. ex." means Reference Example, "Comp. ex." means Comparative Example, and "Conv. ex." means Conventional Example. (The same is applied herein.) | | | | | | | |

### (Evaluation method)

The thus-obtained lead frames of Examples according to the present invention, Reference Examples, and Conventional Examples, as shown in Table 1, were evaluated in the following experiments and criteria. The results are shown in Table 2.

### (1A) Reflectance measurement:

With a spectrophotometer (U-4100 (trade name, manufactured by Hitachi High-Technologies Corporation)), continuous measurement to the respective sample was made on the total reflectance over wavelength range 300 nm to 800 nm. Among these, Table 2 shows the total reflectance (%) at 340 nm, 375 nm, and 400 nm in the ultraviolet region to the near-ultraviolet region, and at 450 nm and 600 nm in the visible light region. Required characteristics are defined: the reflectance of 60% or more at wavelength 340 nm, the reflectance of 75% or more at 375 nm, the reflectance of 80% or more at 400 nm, and the reflectance of 90% or more at wavelength 450 nm and 600 nm in the visible light region, respectively.

### (1 B) Heat resistance:

The discoloration states of the samples after subjected to a heat treatment in the air for 3 hours at a temperature of 150°C or 190°C were observed, respectively, with the naked eyes. A sample without discoloration was judged to be "good" and is marked with "O"; a sample which exhibited slight discoloration to brown was judged to be "fair" and is marked with "Δ"; and a sample which turned completely to brown was judged to be "poor" and is marked with "×", respectively in the table. Samples which were evaluated as "fair" or better are judged to be of a practically acceptable level.

### (1 C) Bending property:

The samples were subjected to 90° bending in the direction parallel to the rolling lines, by using a 1-ton press machine, with bending radius 0.2 mm. The apex at the thus-bent portion of the samples was observed with a stereoscopic microscope with a magnification of 100X, to confirm whether cracks were occurred or not. A sample which had no cracks was judged to be "excellent" and is marked with " 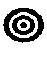 "; a sample which had slight cracks occurred in the outermost layer but in which the cracks did not reach to the substrate was judged to be "good" and is marked with "O"; a sample which had slight cracks occurred in the outermost layer but which had no cracks observed in the substrate, was judged to be "fair" and is marked with "Δ"; and a sample which had cracks occurred reaching to the substrate was judged to be "poor" and is marked with "x", respectively in the table. Samples which were evaluated as "fair" or better are judged to be of a practically acceptable level.

{Table 2}

**Table 2**

| | Reflectance | | | | | Heat resistance 150°C 3h | Heat resistance 190°C 3h | Bending property R=0.2mn |
|---|---|---|---|---|---|---|---|---|
| | @ 340nm | @ 375nm | @ 400nm | @ 450nm | @ 600nm | | | |
| Ex. 1 | 69 | 88 | 90 | 97 | 98 | ○ | ○ | ○ |
| Ex. 2 | 69 | 88 | 90 | 97 | 97 | ○ | ○ | ○ |
| Ex. 3 | 68 | 87 | 89 | 95 | 96 | ○ | ○ | ○ |
| Ex. 4 | 65 | 82 | 83 | 92 | 93 | ○ | ○ | ○ |
| Ex. 5 | 62 | 77 | 82 | 90 | 92 | ○ | ○ | ○ |
| Ex. 6 | 70 | 87 | 92 | 98 | 99 | ○ | ○ | ○ |
| Ex. 7 | 68 | 87 | 89 | 96 | 97 | ○ | ○ | ○ |
| Ex. 8 | 68 | 87 | 89 | 96 | 96 | ○ | ○ | ○ |
| Ex. 9 | 67 | 86 | 88 | 94 | 95 | ○ | ○ | ○ |
| Ex. 10 | 64 | 81 | 82 | 91 | 92 | ○ | ○ | ○ |
| Ex. 11 | 61 | 76 | 81 | 90 | 91 | Δ | Δ | ○ |
| Ex. 12 | 68 | 87 | 90 | 97 | 98 | ○ | ○ | ○ |
| Ex. 13 | 69 | 88 | 90 | 96 | 97 | ○ | ○ | ○ |
| Ex. 14 | 68 | 88 | 89 | 97 | 98 | ○ | ○ | ○ |
| Ex. 15 | 62 | 75 | 84 | 91 | 92 | ○ | ○ | ⊙ |
| Ex. 16 | 64 | 77 | 85 | 93 | 94 | ○ | ○ | ⊙ |
| Ex. 17 | 66 | 81 | 86 | 94 | 95 | ○ | ○ | ⊙ |
| Ex. 18 | 68 | 84 | 88 | 96 | 98 | ○ | ○ | ⊙ |
| Ex. 19 | 70 | 89 | 93 | 98 | 99 | ○ | ○ | ○ |
| Ex. 20 | 71 | 89 | 94 | 98 | 99 | ○ | ○ | Δ |
| Ex. 21 | 71 | 90 | 94 | 98 | 99 | ○ | ○ | Δ |
| Ex. 22 | 69 | 88 | 90 | 96 | 97 | ○ | ○ | ○ |
| Ex. 23 | 66 | 85 | 87 | 93 | 94 | ○ | Δ | ○ |
| Ex. 24 | 63 | 82 | 84 | 90 | 91 | ○ | ○ | ○ |
| Ex. 25 | 66 | 85 | 87 | 93 | 94 | ○ | ○ | ○ |
| Ex. 26 | 61 | 80 | 83 | 90 | 90 | ○ | ○ | ○ |
| Ex. 27 | 67 | 86 | 88 | 94 | 95 | ○ | ○ | ○ |
| Ex. 28 | 66 | 85 | 87 | 93 | 94 | ○ | ○ | ○ |
| Ex. 29 | 69 | 88 | 90 | 96 | 97 | ○ | ○ | ○ |
| Ex. 30 | 69 | 88 | 90 | 96 | 97 | ○ | ○ | ○ |
| Ex. 31 | 67 | 87 | 89 | 95 | 96 | ○ | ○ | ○ |
| Ex. 32 | 68 | 87 | 90 | 96 | 96 | ○ | ○ | ○ |
| Ex. 33 | 69 | 88 | 90 | 96 | 97 | ○ | ○ | ○ |
| Ex. 34 | 68 | 87 | 90 | 96 | 96 | ○ | ○ | ○ |
| Ex. 35 | 67 | 87 | 89 | 96 | 98 | ○ | ○ | ○ |
| Ex. 36 | 66 | 87 | 88 | 96 | 98 | ○ | ○ | ○ |
| Ex. 37 | 66 | 88 | 90 | 96 | 98 | ○ | ○ | ○ |
| Ex. 38 | 67 | 87 | 89 | 96 | 98 | ○ | ○ | ○ |
| Ref. ex. 1 | 56 | 71 | 76 | 85 | 86 | × | × | ○ |
| Ref. ex. 2 | 62 | 71 | 81 | 89 | 93 | ○ | ○ | ⊙ |
| Ref. ex. 3 | 71 | 90 | 94 | 98 | 99 | ○ | ○ | × |
| Ref. ex. 4 | 57 | 75 | 79 | 83 | 84 | Δ | × | ⊙ |
| Ref. ex. 5 | 55 | 73 | 78 | 82 | 83 | Δ | × | ⊙ |
| Conv. ex. 1 | 62 | 64 | 78 | 87 | 93 | ○ | ○ | ⊙ |
| Conv. ex. 2 | 56 | 55 | 68 | 79 | 85 | Δ | × | ⊙ |
| Conv. ex. 3 | 71 | 82 | 86 | 88 | 89 | Δ | × | Δ |
| Conv. ex. 4 | 59 | 61 | 77 | 86 | 90 | ○ | Δ | ⊙ |

As is apparent from these results, the followings can be understood, by the comparison of Examples which were subjected to the area reduction working, with Conventional Examples 1, 2, and 4 which were subjected to neither area reduction working by rolling nor heat treatment. The samples of Examples were superior in the reflectance at 340 nm to 400 nm of the ultraviolet to near-ultraviolet region, and particularly at 375 nm, satisfying 60% or more at 340 nm, 75% or more at 375 nm, and 80% or more at 400 nm. Further, in Conventional Example 3 which was subjected to the heat treatment at 320°C for 30 seconds after plating, the reflectance in the overall range, and particularly in the visible light region, was lower than that of Examples. In this regard, it is presumed that while the example of Patent Literature 2 utilized an alumina substrate, which is a ceramics substance, a lead frame material which uses a metal in the substrate as in the case of the present invention undergoes diffusion of the components of the base material and substrate, due to being subjected to the heat treatment at 320°C for 30 seconds. Thus, it is further presumed that when the heat treatment was carried out in the air, oxidation of the substrate component proceeded, to result in heat resistance lowered, as shown in Table 2.
Further, it is understood that when the Ag thickness is small, heat resistance is apt to be poor, as in the cases of Conventional Examples 2 and 4.

In Reference Example 1, it is found that, since the coating thickness of the outermost layer was as small as 0.1 µm, the heat resistance was poor, and Reference Example 1, which was improved in the reflectance at wavelength 375 nm and 400 nm, was still inferior to Example 11. Thus, it is understood that the outermost layer coating thickness is preferably 0.2 µm or more.
In Reference Example 2, since the working ratio at the time of rolling after the formation of the reflection layer was as low as 0.5%, the reflectance was improved as compared to the case where no rolling was conducted, but the reflectance was still at a level that cannot be considered satisfactory.
In Reference Example 3, the area reduction ratio exceeded 80%, but it was confirmed that the reflectance and heat resistance were excellent, while the bending property was poor. Thus, it is understood that the area reduction ratio is preferably 1% to 80%. Further, when the bending property is emphasized, an area reduction ratio of 20% to 60% is more preferable.
Reference Example 4 and Reference Example 5 are examples of conducting a heat treatment (low-temperature annealing) after the plating and rolling. The reflectance of those was lowered by about 10% in the entire region, and since the thermal history was excessive due to the low-temperature annealing, the reflectance was lowered. Based on this, it is understood that in the case of applying a heat treatment after rolling, it is necessary to apply the heat treatment, sufficiently taking the resultant reflectance into consideration.

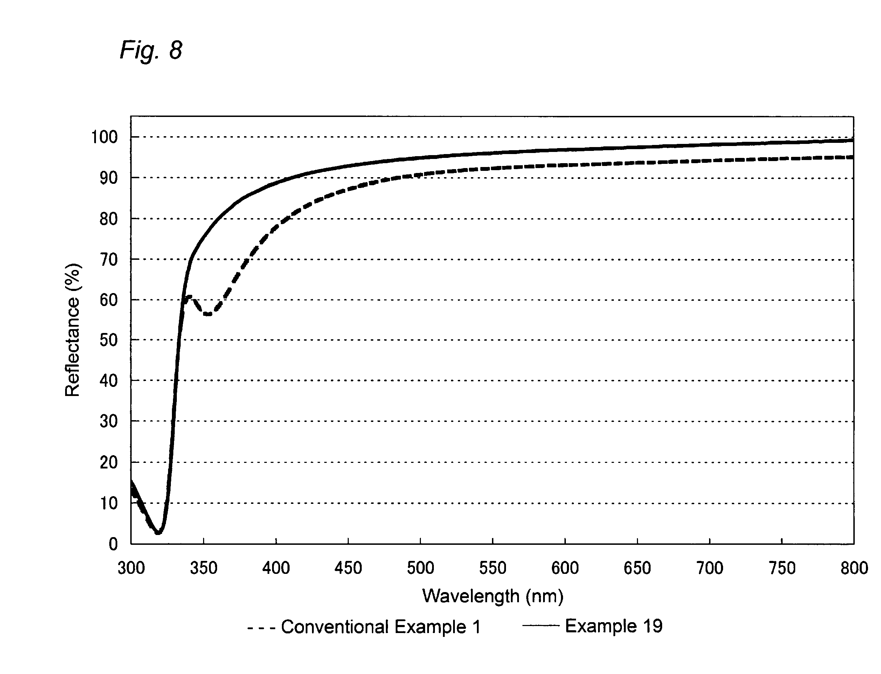

Fig. 8 shows the results of measuring the reflectance in Conventional Example 1 and Example 19. These are results showing Example 19 which was subjected to plastic working after plating, in comparison with Conventional Example 1 which was merely plated in a conventional and usual manner (no plastic working and no heat treatment was conducted). From those, it can be seen that the example according to the present invention had no absorption peak at wavelength 345 to 355 nm disappeared, and exhibited the remarkably excellent reflectance in the visible light region. This reflectance is very close to the physical limit reflectance of silver, and is a reflectance that has not been observed hitherto. Thus, it can be seen that the sample of the example can be very suitably used as a lead frame for an optical semiconductor device, at wavelength 340 to 800 nm from the near-ultraviolet to visible light region. In regard to the results of Conventional Example 1 as shown in the figure, it is thought that the reflectance on the lower wavelength side is lower than the reflectance of Conventional Example 3.

### (Example 2)

As Example 2, substrates with width 100 mm, as shown in Table 3, were subjected to the respective pretreatment in the same manner as in Example 1, followed by electroplating, as shown in Table 3, in the same manner as in Example 1. That is, substrates with thickness 0.25 mm or 0.83 mm were used, and each of the substrates was plated with Ag on each side such that the Ag coating thickness after rolling would be 3 µm. Then, the resultant substrate was subjected to rolling at a working ratio of 40% at the time of rolling after the formation of the reflection layer, to obtain strips with thicknesses 0.15 mm or 0.5 mm, respectively. Then, the strips were subjected to punching with a press, followed by electroplating, to form a plating coating favorable in solder wettability, only in the external lead section, by means of a resist mask, and removing the resist, to obtain Examples 39 to 50 and Reference Examples 6 to 9, having the structures as shown in Table 3, respectively.
Further, in Conventional Examples 5 to 8, lead frames as shown in Table 3 were produced, by subjecting strips with thickness 0.15 mm or 0.5 mm and width 100 mm, to press punching and then Ag plating.
In all cases, the width of the lead section to be soldered was set to 3 mm or 0.5 mm.

{Table 3}

**Table 3**

| | Substrate | Lead thickness | Lead width | Intermediate layer | Outermost layer at LED section | Area reduction ratio | Plating at lead section |
|---|---|---|---|---|---|---|---|
| Ex. 39 | C14410 | 0.15mm | 3mm | None | Ag=3µm | 40% | Ag=0.3µm |
| Ex. 40 | C14410 | 0.15mm | 0.5mm | None | Ag=3µm | 40% | Ag=0.3µm |
| Ex. 41 | C14410 | 0.15mm | 3mm | None | Ag=3µm | 40% | Sn=0.3µm |
| Ex. 42 | C14410 | 0.15mm | 0.5mm | None | Ag=3µm | 40% | Sn=0.3µm |
| Ex. 43 | C14410 | 0.15mm | 3mm | None | Ag=3µm | 40% | Au=0.1µm |
| Ex. 44 | C14410 | 0.15mm | 0.5mm | None | Ag=3µm | 40% | Au=0.1µm |
| Ex. 45 | C14410 | 0.5mm | 3mm | None | Ag=3µm | 40% | Ag=0.3µm |
| Ex. 46 | C14410 | 0.5mm | 0.5mm | None | Ag=3µm | 40% | Ag=0.3µm |
| Ex. 47 | C14410 | 0.5mm | 3mm | None | Ag=3µm | 40% | Sn=0.3µm |
| Ex. 48 | C14410 | 0.5mm | 0.5mm | None | Ag=3µm | 40% | Sn=0.3µm |
| Ex. 49 | C14410 | 0.5mm | 3mm | None | Ag=3µm | 40% | Au=0.1µm |
| Ex. 50 | C14410 | 0.5mm | 0.5mm | None | Ag=3µm | 40% | Au=0.1µm |
| Ref. ex. 6 | C14410 | 0.15mm | 3mm | None | Ag=3µm | 40% | None |
| Ref. ex. 7 | C14410 | 0.15mm | 0.5mm | None | Ag=3µm | 40% | None |
| Ref. ex. 8 | C14410 | 0.5mm | 3mm | None | Ag=3µm | 40% | None |
| Ref. ex. 9 | C14410 | 0.5mm | 0.5mm | None | Ag=3µm | 40% | None |
| Conv. ex. 5 | C14410 | 0.15mm | 3mm | None | Ag=3µm | None | None |
| Conv. ex. 6 | C14410 | 0.15mm | 0.5mm | None | Ag=3µm | None | None |
| Conv. ex. 7 | C14410 | 0.5mm | 3mm | None | Ag=3µm | None | None |
| Conv. ex. 8 | C14410 | 0.5mm | 0.5mm | None | Ag=3µm | None | None |

### (Evaluation method)

The thus-obtained lead frames of Examples according to the present invention, Reference Examples, and Conventional Examples, as shown in Table 3, were evaluated in the following experiments and criteria. The results are shown in Table 4.

### (2A) Reflectance measurement:

With a spectrophotometer U-4100 (trade name, manufactured by Hitachi High-Technologies Corporation), continuous measurement to the respective sample was made on the total reflectance over 300 nm to 800 nm. Among these, Table 4 shows the total reflectance (%) at wavelength 340 nm, at wavelength 375 nm, at wavelength 400 nm, at wavelength 450 nm, and at wavelength 600 nm.
With respect to the total reflectance, taking the practical utility into consideration, required characteristics are defined: the reflectance of 60% or more at wavelength 340 nm, the reflectance of 75% or more at 375 nm, the reflectance of 80% or more at 400 nm, and the reflectance of 90% or more at wavelength 450 nm and 600 nm in the visible light region, respectively.

### (2B) Soldering property:

The samples were placed in a solder checker (SAT-5100 (trade name, manufactured by Rhesca Corp.)), and after heating in the air at 150°C for 3 hours, the solder wetting time period at the lead section was evaluated, respectively. The details of the measurement conditions are shown below, and a solder wetting time period of 1 second or less was judged to be satisfactory.
Kind of Solder: Sn-3Ag-0.5Cu
Temperature: 250°C
Flux: isopropyl alcohol-25% rosin
Soaking rate: 25mm/sec
Time period for soaking: 10 sec
Depth for soaking: 10mm

{Table 4}

**Table 4**

| | Reflectance at reflection section | | | | | Solder wetting time period after 150°C 3h |
|---|---|---|---|---|---|---|
| | @340nm | @375nm | @400nm | @450nm | @600nm | |
| Ex. 39 | 68 | 87 | 91 | 97 | 98 | 0.2 to 0.5 sec |
| Ex. 40 | 67 | 87 | 90 | 96 | 97 | 0.2 to 0.5 sec |
| Ex. 41 | 68 | 86 | 89 | 96 | 97 | 0.2 to 0.5 sec |
| Ex. 42 | 67 | 87 | 91 | 97 | 98 | 0.2 to 0.5 sec |
| Ex. 43 | 68 | 87 | 88 | 97 | 97 | 0.2 to 0.5 sec |
| Ex. 44 | 68 | 87 | 89 | 96 | 97 | 0.2 to 0.5 sec |
| Ex. 45 | 67 | 86 | 91 | 97 | 97 | 0.4 to 0.8 sec |
| Ex. 46 | 68 | 87 | 90 | 96 | 97 | 0.3 to 0.7 sec |
| Ex. 47 | 68 | 87 | 89 | 97 | 97 | 0.4 to 0.8 sec |
| Ex. 48 | 67 | 87 | 91 | 97 | 98 | 0.3 to 0.7 sec |
| Ex. 49 | 68 | 86 | 88 | 97 | 97 | 0.4 to 0.8 sec |
| Ex. 50 | 68 | 87 | 89 | 96 | 97 | 0.3 to 0.7 sec |
| Ref. ex. 6 | 67 | 86 | 91 | 96 | 97 | 0.2 to 0.6 sec |
| Ref. ex. 7 | 68 | 87 | 90 | 97 | 98 | 0.3 to 0.6 sec |
| Ref. ex. 8 | 68 | 87 | 89 | 97 | 98 | 0.5 to 1.5 sec |
| Ref. ex. 9 | 67 | 87 | 91 | 97 | 97 | >3 sec |
| Conv. ex. 5 | 61 | 63 | 78 | 86 | 93 | 0.2 to 0.5 sec |
| Conv. ex. 6 | 60 | 63 | 77 | 87 | 92 | 0.2 to 0.5 sec |
| Conv. ex. 7 | 62 | 64 | 78 | 86 | 92 | 0.4 to 0.8 sec |
| Conv. ex. 8 | 61 | 64 | 76 | 87 | 93 | 0.3 to 0.7 sec |

From Example 2, the followings are understood, with respect to Examples, Reference Examples, and Conventional Examples.
(a) When a plated Ag coating has a rolled reflection layer with thickness 3 µm, the reflectance is satisfactory as in Example 1.
(b) It is found that in each of Examples in which the external leads were plated with Ag, Sn, or Au of a plating coating with satisfactory solder wettability, there was no problem with the soldering property.
(c) In Reference Examples where plating with satisfactory solder wettability was not applied to the external leads, there was no problem with a small sheet thickness and a broad width, but the wetting time period was slightly longer in a narrow width. In the case of a large sheet thickness and a broad width, the wetting time period became slightly long, but in the case of a narrow width, the wetting time period became significantly long.
(d) From the items (b) and (c), in the case of an application where high reliability of the soldering property is required, or in the case of a shape which is difficult to be wetted with solder due to sheet thickness and width, it is preferable to apply plating with satisfactory solder wettability to external leads.
In Examples described above, examples of plating a pure metal (Ag, Sn, or Au) as the plating to the external lead are shown, but it was also confirmed that the same effects were exhibited with an alloy of any of these metals.

### (Example 3)

This is an example of the embodiment characterized by the plating microstructure residual ratio.
As Example 3, electric conductive substrates, as shown in Table 5, with thickness 0.25 mm and width 180 mm, were subjected to the respective pretreatment in the same manner as described above, followed by electroplating in the same manner as described above. Then, in order to cause plastic deformation to the resultant Ag plating layer, the Ag plated substrates were subjected to rolling or pressing, with changing the working ratio, to obtain lead frames of Examples 101 to 121 and Reference Examples 101, respectively. Reference Example 102 was a simulation of Comparative Example 1 of Patent Literature 3, and Reference Example 103 was a simulation of Example 2 of Patent Literature 3, respectively, and those samples were provided by rolling, followed by a heat treatment at 240°C for 4 hours (heat treatment finished products). In Conventional Example 101, an electric conductive substrate, as shown in Table 5, with sheet thickness 0.25 mm and width 180 mm, was subjected to the pretreatment in the same manner as described above, followed by electroplating in the same manner as described above, without being subjected to rolling, to obtain a lead frame, which is a plating finished product. In Conventional Example 102, the plated material obtained in Conventional Example 101 was subjected to a heat treatment at 300°C for 5 minutes, under a nitrogen atmosphere with residual oxygen concentration 500 ppm or less, to provide a lead frame whose grain size was adjusted by the heat treatment.
(Those of Examples and Reference Examples, which had no intermediate layer, each correspond to the structure of the lead frame, as shown in Fig. 1, and those of Examples, which had the intermediate layer, each correspond to the structure of the lead frame, as shown in Fig. 2.)

With respect to the conditions for silver strike plating, the conditions described above were changed as shown below. Other treatments were carried out in the same manner as described above.

### [Ag strike plating]

Plating liquid: KAg(CN)₂ 4.45 g/L, KCN 60 g/L
Plating conditions: Current density 5 A/dm², temperature 25°C
{Table 5}

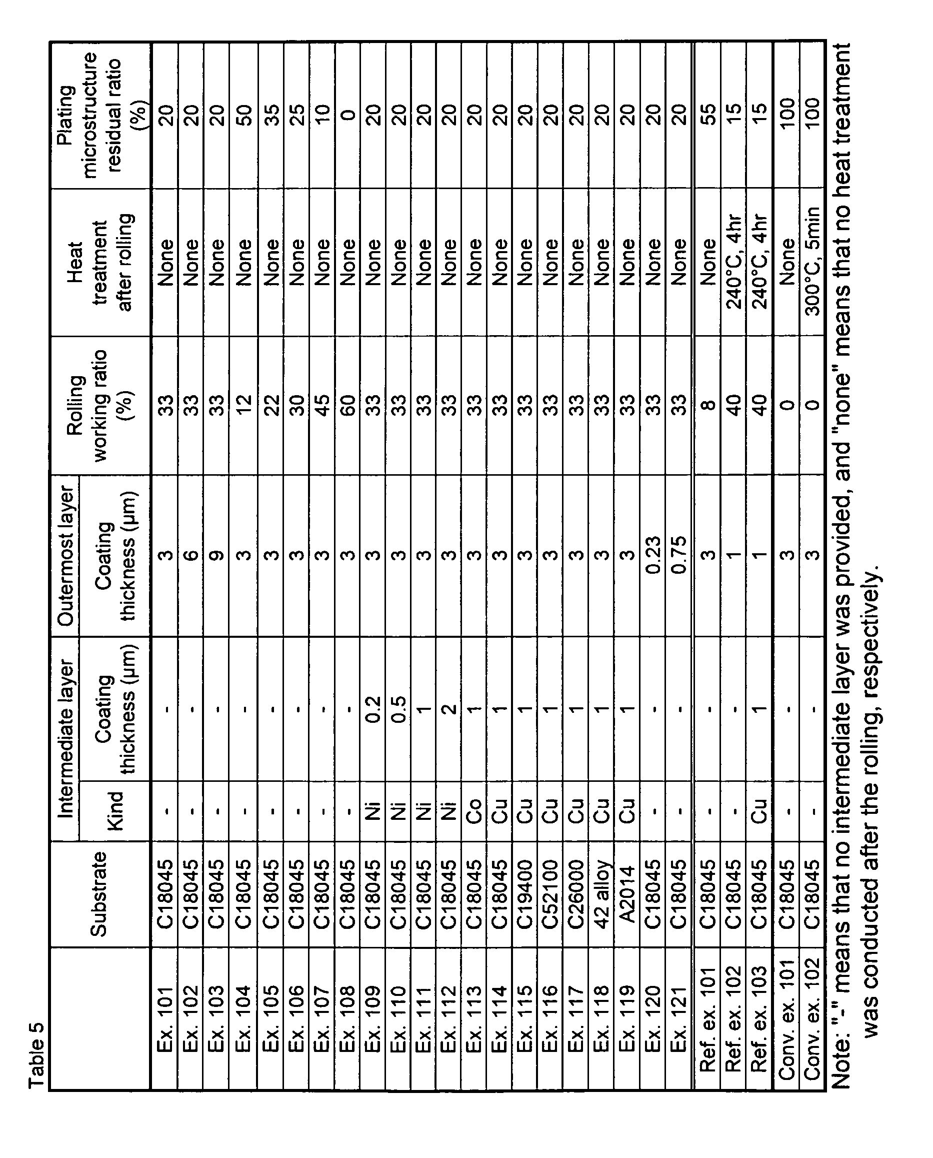

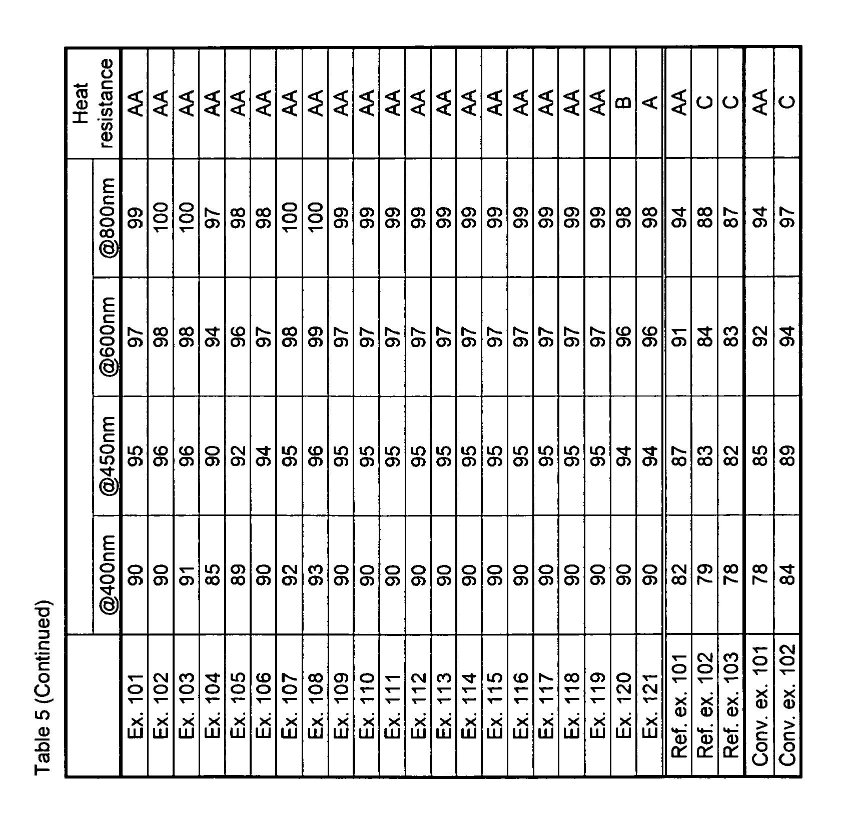

### (Evaluation method)

The thus-obtained lead frames of Examples according to the present invention, Reference Examples, and Conventional Examples, as shown in Table 5, were evaluated in the following experiments and criteria. The results are shown in Table 5. Herein, a Conventional Example means one equivalent to a conventional technique, among Comparative Examples.

### (3A) Reflectance measurement:

With a spectrophotometer V660 (trade name, manufactured by JASCO Corporation), continuous measurement to the respective sample was made on the total reflectance over 300 nm to 800 nm. Among these, Table 5 shows the total reflectance (%) at 400 nm, 450 nm, 600 nm, and 800 nm. Required characteristics are defined: the reflectance of 85% or more at wavelength 400 nm, and the reflectance of 90% or more at wavelength from 450nm to 800nm nm, respectively.

### (3B) Heat resistance:

The respective sample was subjected to a heat treatment in the air at a temperature of 150°C for 3 hours, and then the reflectance measurement was conducted in the same manner as above. Based on the results, a sample in which the total reflectance at wavelength 450 nm did not change at all was rated as "AA"; a sample in which the lowering in the reflectance was 2% or less was rated as "A"; a sample in which the lowering in the reflectance was more than 2% and not more than 5% was rated as "B"; and a sample in which the lowering in the reflectance was more than 5% was rated as "C". The results are shown in Table 5, and the samples rated as B or better are of a practically acceptable level, which is excellent in the heat resistance and can give a stable reflectance.

As is apparent from the results, Examples were superior in the reflectance at 400 nm to 800 nm to Conventional Examples, and satisfied the reflectance of 85% or more at 400 nm, and 90% or more at 450 nm to 800 nm. Particularly, Examples with the plating microstructure residual ratio of 50% or less, satisfied the reflectance of 90% or more at wavelength 450 nm, and 95% or more at wavelength 450 nm to 800 nm. Thus, it is understood that Examples according to the present invention exhibit the reflectance at a quite excellent level that was not able to be achieved with the conventional technique. It was also confirmed that the reflectance is also excellent in the near-ultraviolet region.
On the other hand, in Conventional Example 101, which was a usual silver-plated product, the reflectance at wavelength 400 nm was 85% or less, and the reflectance at wavelength 450 nm was 85%. This implies that when a chip emitting light at 450 nm is mounted, Examples according to the present invention each have a luminance higher by 5% to 10% than Conventional Example 101. Based on this, it is expected that the lead frame according to the present invention can be preferably used for optical semiconductors, which utilize this wavelength region, owing to the improvement in the reflectance. Further, in Conventional Example 102, which was an example of coarsening the grain size to 0.5 µm or more by applying a heat treatment after silver plating, it is understood that the initial reflectance was slightly less than 85% at wavelength 400 nm, and further the heat resistance was poorer. This is presumed that, when a lead frame of this type is subjected to such a heat treatment as in Conventional Example 2, the copper component of the substrate becomes apt to diffuse to the surface layer, resulting in a poor heat resistance. Thus, according to Examples in which at least the surface of the plating microstructure is deformed by mechanical working, lead frames for optical semiconductors can be provided, which are excellent in the heat resistance and which exhibit the reflectance that is not deteriorated due to a heat applied thereto.
In Reference Example 101, the plating microstructure residual ratio of the reflection layer formed of silver exceeded 50%, and as a result, the reflectance at wavelength 400 nm and 450 nm were less than 85% and 90%, respectively. Thus, it is understood that the improvement in the reflectance is insufficient.
Further, in Reference Example 102 and Reference Example 103, the plating microstructure residual ratio of the reflection layer formed of silver was less than 50%, but an excessive heat treatment was applied after rolling, respectively. As a result, lowering in the reflectance is large, and lowering in the reflectance in the entire wavelength region can be seen. Thus, it is understood that it is necessary to set the heat treatment conditions not exceeding those at an appropriate level as mentioned above.
From these results, after the reflection layer made of silver at the outermost layer is formed by an electroplating method, by setting the plating microstructure residual ratio to 50% or less, a reflectance of 85% or more can be achieved at wavelength 400 nm and a reflectance of 90% or more can be achieved at wavelength from 450 nm to 800 nm. Thus, it is understood that, by using the lead frames of the present invention in optical semiconductor devices, excellent optical semiconductor devices can be provided, which exhibit excellent luminance, and which are excellent in the heat resistance, to make it possible to maintain the high luminance over a long time period.

### (Example 4)

This is an Example of the embodiment characterized by the surface roughness.
As Example 4, as a metal substrate, use was made of a copper-based alloy "EFTEC64T-C (C18045)" (trade name), manufactured by Furukawa Electric Co., Ltd. The width thereof was set to 100 mm. The substrate was subjected to a pretreatment as shown below, followed by electroplating as shown below, to form a silver plating layer with a thickness of 1.0 µm.

### (Pretreatment conditions)

### [Electrolytic degreasing]

Degreasing liquid: NaOH 60 g/L
Degreasing conditions: 2.5 A/dm², temperature 60°C, degreasing time period 60 seconds

### [Acid pickling]

Acid pickle: 10% sulfuric acid
Acid pickling conditions: 30 seconds dipping, room temperature

### [Ag strike plating]

Plating liquid: KAg(CN)₂ 4.45 g/L, KCN 60 g/L
Plating conditions: Current density 5 A/dm², temperature 25°C

### [Ag plating]

Plating liquid: AgCN 50 g/L, KCN 100 g/L, K₂O₃ 30 g/L
Plating conditions: Current density 1 A/dm², temperature 30°C

In the step of rolling in the course of producing the metal substrate, the macroscopic surface roughness was controlled, by changing the roll roughness at the time of finish rolling. When the roll roughness was small, a substrate small in surface roughness was obtained, and when the roll roughness was large, a substrate large in surface roughness was obtained. In the following test examples, use was made of skin pass rolls (the surface is smoother than the following 0.1S rolls), 0.1S rolls, 0.2S rolls, 0.4S rolls, and 0.8S rolls, in the order from the smaller side of the roll surface roughness Rz. The roll surface is smoother in the order of the skin pass rolls, 0.1 S rolls, 0.2S rolls, 0.4S rolls, and 0.8S rolls. The macroscopic surface roughness was controlled such that the contact needle-type macroscopic surface roughness given with those rolls would be Ra ≈ 0.005 µm, 0.01 µm, 0.02 µm, 0.03 µm, and 0.04 µm, respectively, in the order.

With respect to the thus-plated samples obtained by applying plating to the surface of the substrates, use was made of samples of the metal substrates having surface states different from each other, and they were subjected to polishing with colloidal silica (OP-S suspension (OPSIF- 5-liter volume), manufactured by Marumoto Struers) for the time period, as shown in Table 6, to control to attain the target microscopic surface roughness. Herein, zero (0) second means a plating finished sample without being polished.

The macroscopic surface roughness Ra was measured with a contact-type surface roughness meter (SE-30H, product name, manufactured by Kosaka Laboratory, Ltd.). The measurement distance was 4 mm, and the speed of needle was 0.8 mm/s.
The microscopic surface roughness Sa was measured with an AFM (Mobile S, product name, manufactured by Nanosurf AG, contact needle: CONTR-10#). The angle of view was set to 6.16 µm × 6.16 µm.

Each of the samples was cut to a size of 2.5 cm × 2.5 cm, followed by subjecting the respective sample to continuous measurement on the total reflectance over 300 nm to 800 nm, with a spectrophotometer (U-4100 (trade name, manufactured by Hitachi High-Technologies Corporation)). The wavelengths indicated in Examples are: 375 nm as a representative value of the ultraviolet light region; 400 nm as the lower limit and 800 nm as the upper limit each as the threshold values of the visible light region; and 450 nm, 520 nm, 590 nm, and 660 nm as representative wavelengths of blue color, green color, yellow color, and red color, respectively, in the visible light region. A total reflectance of 80% or more in the visible light region (400 nm to 800 nm), and a total reflectance of 70% or more in the near-ultraviolet region (for example, 375 nm) are, respectively, judged to be acceptable ("to pass"), and a reflectance less than these are judged to be unacceptable ("not to pass").
The total reflectance at the respective wavelength is shown in Table 6. From the results of the continuous measurement, it was confirmed that there was no rapid lowering in the total reflectance between the respective above two wavelengths.

The adhesiveness to resins was evaluated, by forming a coating of a silicone sealing resin for LED, onto the plated metal substrate, and conducting a cross-cut test on the resultant resin coating (1 mm × 1 mm, peeling tape: 631 S #25 polyester film adhesive tape, manufactured by Teraoka Seisakusho Co., Ltd.). The evaluation criteria are as follows.
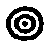 : No detachment is observed (excellent)
○: Lift-up is observed at the edge (good)
Δ: Peeling-off is observed to some extent (fair)
×: Peeling-off occurs (poor)

{Table 6}

**Table 6**

| Ag | Rz (µm) of rolls when rolling substrate | Contact type | Polishing time period (sec) | AFM | Total reflectance | | | | | | | Adhesiveness to resins |
|---|---|---|---|---|---|---|---|---|---|---|---|---|
| | | Macroscopic surface roughness | | Microscopic surface roughness | 375 nm | 400 nm | 450 nm | 520 nm | 590 nm | 660 nm | 800 nm | |
| | | Ra (µm) | | Sa (nm) | (%) | (%) | (%) | (%) | (%) | (%) | (%) | |
| Comp. ex. 201 | 0.005 | 0.005 | 0 | 98.6 | 61 | 70 | 76 | 79 | 80 | 80 | 81 | × |
| Ref. ex. 201 | 0.005 | 0.007 | 5 | 60.2 | 62 | 71 | 77 | 79 | 81 | 82 | 82 | × |
| Ref. ex. 202 | 0.005 | 0.006 | 10 | 48.6 | 72 | 80 | 82 | 83 | 85 | 86 | 86 | × |
| Ref. ex. 203 | 0.005 | 0.006 | 20 | 29.0 | 77 | 85 | 88 | 90 | 93 | 93 | 94 | × |
| Ref. ex. 204 | 0.005 | 0.005 | 40 | 9.8 | 90 | 91 | 96 | 97 | 98 | 98 | 99 | × |
| Ref. ex. 205 | 0.005 | 0.005 | 60 | 4.9 | 94 | 95 | 98 | 98 | 98 | 99 | 99 | × |
| Comp. ex. 202 | 0.01 | 0.012 | 0 | 97.5 | 62 | 70 | 76 | 78 | 80 | 81 | 81 | Δ |
| Ref. ex. 206 | 0.01 | 0.011 | 5 | 61.3 | 63 | 71 | 77 | 79 | 81 | 82 | 82 | Δ |
| Ex. 201 | 0.01 | 0.010 | 10 | 50.0 | 72 | 80 | 82 | 84 | 86 | 85 | 86 | Δ |
| Ex. 202 | 0.01 | 0.011 | 20 | 28.9 | 77 | 85 | 87 | 91 | 93 | 94 | 94 | Δ |
| Ex. 203 | 0.01 | 0.010 | 40 | 9.9 | 90 | 91 | 96 | 97 | 98 | 98 | 99 | Δ |
| Ex. 204 | 0.01 | 0.012 | 60 | 4.7 | 95 | 96 | 98 | 99 | 98 | 99 | 99 | Δ |
| Comp. ex. 203 | 0.02 | 0.021 | 0 | 98.8 | 62 | 70 | 76 | 79 | 81 | 81 | 81 | ○ |
| Ref. ex. 207 | 0.02 | 0.022 | 5 | 63.8 | 63 | 71 | 77 | 79 | 82 | 82 | 82 | ○ |
| Ex. 205 | 0.02 | 0.023 | 10 | 49.9 | 72 | 80 | 82 | 85 | 86 | 86 | 86 | ○ |
| Ex. 206 | 0.02 | 0.023 | 20 | 29.8 | 77 | 85 | 88 | 92 | 93 | 94 | 94 | ○ |
| Ex. 207 | 0.02 | 0.020 | 40 | 10.0 | 91 | 91 | 96 | 97 | 98 | 99 | 99 | ○ |
| Ex. 208 | 0.02 | 0.022 | 60 | 4.9 | 96 | 96 | 98 | 99 | 99 | 99 | 99 | ○ |
| Comp. ex. 204 | 0.03 | 0.031 | 0 | 97.7 | 62 | 70 | 77 | 80 | 80 | 81 | 81 | 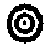 |
| Ref. ex. 208 | 0.03 | 0.032 | 5 | 60.5 | 63 | 71 | 78 | 81 | 81 | 81 | 82 | 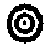 |
| Ex. 209 | 0.03 | 0.031 | 10 | 49.2 | 73 | 80 | 82 | 85 | 86 | 86 | 86 | 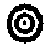 |
| Ex. 210 | 0.03 | 0.030 | 20 | 30.0 | 77 | 85 | 88 | 92 | 93 | 95 | 94 | 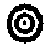 |
| Ex. 211 | 0.03 | 0.030 | 40 | 9.7 | 91 | 90 | 97 | 97 | 98 | 99 | 99 | 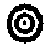 |
| Ex. 212 | 0.03 | 0.033 | 60 | 4.7 | 96 | 96 | 97 | 99 | 99 | 99 | 99 | 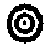 |
| Comp. ex. 205 | 0.04 | 0.043 | 0 | 99.5 | 63 | 70 | 76 | 79 | 81 | 81 | 81 | 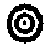 |
| Ref. ex. 209 | 0.04 | 0.041 | 5 | 61.7 | 64 | 70 | 77 | 79 | 81 | 82 | 82 | 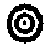 |
| Ex. 213 | 0.04 | 0.041 | 10 | 49.9 | 72 | 80 | 93 | 84 | 87 | 86 | 86 | 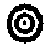 |
| Ex. 214 | 0.04 | 0.042 | 20 | 29.7 | 77 | 85 | 88 | 92 | 93 | 95 | 94 | 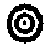 |
| Ex. 215 | 0.04 | 0.044 | 40 | 9.8 | 91 | 91 | 96 | 98 | 99 | 99 | 99 | 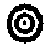 |
| Ex. 216 | 0.04 | 0.040 | 60 | 5.0 | 96 | 96 | 97 | 99 | 99 | 99 | 99 | 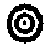 |

### (Example 5)

This is an example of the embodiment characterized by the surface roughness.
As Example 5, the same evaluation was carried out for Au-, Cu-, Pt-, Al-, and Rh-plated materials, respectively, in the same manner as in the evaluation of the above-described Ag-plated material.

As a metal substrate in Example 5, use was made of the same metal substrate as in Example 4. The substrate was subjected to the pretreatment as in Example 4, followed by electroplating shown below, to form a plating layer of the metal, as shown in Table 7, with a thickness of 1.0 µm.
The plating conditions for the respective metal plating utilized are as follows.

### [Au plating]

Plating liquid: KAu(CN)₂ 14.6 g/L, C₆H₈O₇ 150 g/L, K₂C₆H₄O₇ 180 g/L
Plating conditions: Current density 1 A/dm², temperature 40°C

### [Cu plating]

Plating liquid: CuSO₄·5H₂O 250 g/L, H₂SO₄ 50 g/L, NaCl 0.1 g/L
Plating conditions: Current density 6 A/dm², temperature 40°C

### [Pt plating]

Plating liquid: Pt(NO₂)(NH₃)₂ 10 g/L, NaNO₂ 10 g/L, NH₄NO₃ 100 g/L, NH₃ 50 mL/L
Plating conditions: Current density 5 A/dm², temperature 80°C

### [Al sputtering]

Apparatus: SPV-403 (trade name, manufactured by Tokki Corporation)
Target: Purity 99.99%
Sputtering conditions: Sputter rate 27 nm/min, RF Power 100 W, Pressure 3×10⁻³torr, Ar flow rate 50 sccm (standard cc/min, a flow rate at 1atm (atmospheric pressure 1,013 hPa), 25°C)

### [Rh plating]

Plating liquid: RHODEX (trade name, manufactured by Electroplating Engineers of Japan Ltd.)
Plating conditions: 1.3 A/dm², temperature 50°C

With respect to the thus-plated samples, use was made of samples of the metal substrates having surface states different from each other, and they were subjected to polishing with colloidal silica for the time period, as shown in Table 7, to attain the target surface roughness. Herein, zero (0) second means a plating finished sample without being polished. The samples each were subjected to the measurement on the surface roughnesses, e.g. Ra, according to the two kinds of measurement methods in the same manner as in Example 4.
Further, the samples each were subjected to the continuous measurement on the total reflectance in the same manner as in Example 4.
Further, the samples each were subjected to the evaluation of the adhesiveness to resins in the same manner as in Example 4. The evaluation method was the same as in Example 4.
The results are shown in Table 7.

{Table 7}

**Table 7**

| Au | Rz (µm) of rolls when rolling substrate | Contact type | Polishing time period (sec) | AFM | Total reflectance | | | | | | | Adhesiveness to resins |
|---|---|---|---|---|---|---|---|---|---|---|---|---|
| | | Macroscopic surface roughness | | Microscopic surface roughness | 375 nm | 400 nm | 450 nm | 520 nm | 590 nm | 660 nm | 800 nm | |
| | | Ra (µm) | | Ra (nm) | (%) | (%) | (%) | (%) | (%) | (%) | (%) | |
| Comp. ex. 206 | 0.005 | 0.007 | 0 | 99.2 | 15 | 16 | 17 | 27 | 46 | 66 | 86 | × |
| Ref. ex. 210 | 0.005 | 0.005 | 60 | 4.9 | 31 | 32 | 33 | 54 | 80 | 88 | 93 | × |
| Comp. ex. 207 | 0.03 | 0.033 | 0 | 97.6 | 16 | 16 | 18 | 28 | 45 | 68 | 85 | 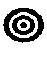 |
| Ex. 217 | 0.03 | 0.030 | 60 | 4.6 | 32 | 33 | 35 | 55 | 82 | 89 | 94 | 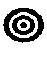 |
| Cu | Rz (µm) of rolls when rolling substrate | Contact type | Polishing time period (sec) | AFM | Total reflectance | | | | | | | Adhesiveness to resins |
| | | Macroscopic surface roughness | | Microscopic surface roughness | 375 nm | 400 nm | 450 nm | 520 nm | 590 nm | 660 nm | 800 nm | |
| | | Ra (µm) | | Ra (nm) | (%) | (%) | (%) | (%) | (%) | (%) | (%) | |
| Comp. ex. 208 | 0.005 | 0.007 | 0 | 98.4 | 24 | 28 | 35 | 43 | 70 | 90 | 94 | × |
| Ref. ex. 211 | 0.005 | 0.006 | 60 | 4.8 | 35 | 37 | 46 | 53 | 82 | 92 | 96 | × |
| Comp. ex. 209 | 0.03 | 0.031 | 0 | 98.9 | 26 | 29 | 36 | 43 | 71 | 90 | 95 | 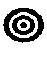 |
| Ex. 218 | 0.03 | 0.032 | 60 | 4.7 | 36 | 38 | 48 | 54 | 83 | 93 | 97 | 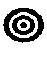 |
| Pt | Rz (µm) of rolls when rolling substrate - | Contact type | Polishing time period (sec) | AFM | Total reflectance | | | | | | | Adhesiveness to resins |
| | | Macroscopic surface roughness | | Microscopic surface roughness | 375 nm | 400 nm | 450 nm | 520 nm | 590 nm | 660 nm | 800 nm | |
| | | Ra(µm) | | Ra(nm) | (%) | (%) | (%) | (%) | (%) | (%) | (%) | |
| Comp. ex. 210 | 0.005 | 0.005 | 0 | 98.2 | 47 | 49 | 53 | 55 | 58 | 61 | 63 | × |
| Ref. ex. 212 | 0.005 | 0.006 | 60 | 4.5 | 55 | 59 | 61 | 64 | 66 | 69 | 72 | × |
| Comp. ex. 211 | 0.03 | 0.032 | 0 | 97.4 | 46 | 48 | 52 | 55 | 57 | 60 | 63 | 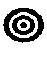 |
| Ex. 219 | 0.03 | 0.032 | 60 | 4.5 | 56 | 58 | 60 | 63 | 66 | 68 | 71 | 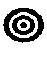 |

| A1 | Rz (µm) of rolls when rolling substrate | Contact type | Polishing time period (sec) | AFM | Total reflectance | | | | | | | Adhesiveness to resins |
|---|---|---|---|---|---|---|---|---|---|---|---|---|
| | | Macroscopic surface roughness | | Microscopic surface roughness | 375 nm | 400 nm | 450 nm | 520 nm | 590 nm | 660 nm | 800 nm | |
| | | Ra (µm) | | Ra (nm) | (%) | (%) | (%) | (%) | (%) | (%) | (%) | |
| Comp. ex. 212 | 0.005 | 0.006 | | 99.1 | 81 | 80 | 77 | 75 | 74 | 71 | 64 | × |
| Ref. ex. 213 | 0.005 | 0.006 | 60 | 4.8 | 93 | 92 | 92 | 91 | 91 | 90 | 86 | × |
| Comp. ex. 213 | 0.03 | 0.030 | 0 | 98.0 | 82 | 81 | 78 | 76 | 75 | 72 | 67 | 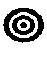 |
| Ex. 220 | 0.03 | 0.032 | 60 | 4.8 | 95 | 94 | 93 | 91 | 92 | 91 | 86 | 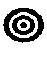 |
| Rh | Rz (µm) of rolls when rolling substrate | Contact type | Polishing time period (sec) | AFM | Total reflectance | | | | | | | Adhesiveness to resins |
| | | Macroscopic surface roughness | | Microscopic surface roughness | 375 nm | 400 nm | 450 nm | 520 nm | 590 nm | 660 nm | 800 nm | |
| | | Ra (µm) | | Ra(nm) | (%) | (%) | (%) | (%) | (%) | (%) | (%) | |
| Comp. ex. 214 | 0.005 | 0.005 | 0 | 98.3 | 57 | 58 | 60 | 62 | 65 | 68 | 72 | × |
| Ref. ex. 214 | 0.005 | 0.006 | 60 | 4.7 | 75 | 75 | 75 | 76 | 77 | 78 | 79 | × |
| Comp. ex. 215 | 0.03 | 0.031 | 0 | 97.5 | 58 | 59 | 60 | 63 | 66 | 69 | 73 | 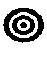 |
| Ex. 221 | 0.03 | 0.032 | 60 | 4.6 | 76 | 77 | 77 | 78 | 79 | 80 | 81 | 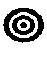 |

### (Example 6)

This is an example of the embodiment characterized by the surface roughness.
As Example 6, the evaluation was carried out in the same manner as in Example 4, except that the surface smoothening by polishing with colloidal silica in Example 4 was changed to surface smoothening by rolling with changing roll surface roughness. Because of the rolling carried out after the formation of the Ag plating layer, the macroscopic surface roughness and the microscopic surface roughness were changed simultaneously. The macroscopic surface roughness and the microscopic surface roughness were changed simultaneously, by changing the rolling working ratio. The microscopic surface roughness was controlled to a certain extent, by changing the roll roughness used in rolling. Even under the same rolling working ratio, when the roll roughness was small, the resultant microscopic surface roughness was made small.
In the table, the rolling working ratio (%) is the value obtained, by dividing the difference between the cross-sectional area of the material before rolling and the cross-sectional area after rolling, by the cross-sectional area of the material before rolling, which is expressed in terms of percentage (%).
The results are shown in Table 8.

{Table 8}

**Table 8**

| Ag | Rz (µm) of rolls when rolling substrate | Contact type | Rolling working ratio % | AFM | Total reflectance | | | | | | | Adhesiveness to resins |
|---|---|---|---|---|---|---|---|---|---|---|---|---|
| | | Macroscopic surface roughness | | Microscopic surface roughness | 375 nm | 400 nm | 450 nm | 520 nm | 590 nm | 660 nm | 800 nm | |
| | | Ra (µm) | | Ra (nm) | (%) | (%) | (%) | (%) | (%) | (%) | (%) | |
| Comp. ex. 216 | 0.01 | 0.040 | 0 | 98.6 | 61 | 70 | 76 | 79 | 80 | 80 | 81 | × |
| Ref. ex. 215 | 0.01 | 0.031 | 5 | 95.6 | 61 | 70 | 76 | 79 | 80 | 80 | 81 | 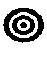 |
| Ref. ex. 216 | 0.01 | 0.022 | 10 | 60.0 | 62 | 71 | 77 | 79 | 81 | 82 | 82 | ○ |
| Ex. 222 | 0.01 | 0.020 | 20 | 48.1 | 72 | 80 | 82 | 83 | 85 | 86 | 86 | ○ |
| Ex. 223 | 0.01 | 0.015 | 30 | 28.7 | 77 | 85 | 88 | 90 | 93 | 93 | 94 | Δ |
| Ex. 224 | 0.01 | 0.013 | 40 | 9.8 | 90 | 91 | 96 | 97 | 98 | 98 | 99 | Δ |
| Ex. 225 | 0.01 | 0.011 | 50 | 3.0 | 94 | 95 | 98 | 98 | 98 | 99 | 99 | Δ |
| Comp. ex. 217 | 0.02 | 0.047 | 0 | 97.5 | 62 | 70 | 76 | 78 | 80 | 81 | 81 | Δ |
| Ref. ex. 217 | 0.02 | 0.045 | 5 | 96.3 | 61 | 70 | 76 | 79 | 80 | 80 | 81 | 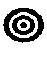 |
| Ref. ex. 218 | 0.02 | 0.038 | 10 | 62.2 | 62 | 71 | 77 | 79 | 81 | 82 | 82 | 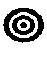 |
| Ex. 226 | 0.02 | 0.034 | 20 | 50.0 | 72 | 80 | 82 | 83 | 85 | 86 | 86 | 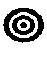 |
| Ex. 227 | 0.02 | 0.030 | 30 | 28.5 | 77 | 85 | 88 | 90 | 93 | 93 | 94 | 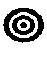 |
| Ex. 228 | 0.02 | 0.023 | 40 | 10.0 | 90 | 91 | 96 | 97 | 98 | 98 | 99 | ○ |
| Ex. 229 | 0.02 | 0.018 | 50 | 4.8 | 94 | 95 | 98 | 98 | 98 | 99 | 99 | Δ |
| Comp. ex. 218 | 0.03 | 0.055 | 0 | 102.3 | 62 | 70 | 76 | 79 | 81 | 81 | 81 | ○ |
| Ref. ex. 219 | 0.03 | 0.054 | 5 | 98.6 | 61 | 70 | 76 | 79 | 80 | 80 | 81 | Δ |
| Ref. ex. 220 | 0.03 | 0.046 | 10 | 60.2 | 62 | 71 | 77 | 79 | 81 | 82 | 82 | 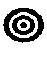 |
| Ex. 230 | 0.03 | 0.040 | 20 | 50.0 | 72 | 80 | 82 | 83 | 85 | 86 | 86 | 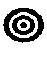 |
| Ex. 231 | 0.03 | 0.037 | 30 | 30.0 | 77 | 85 | 88 | 90 | 93 | 93 | 94 | 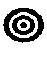 |
| Ex. 232 | 0.03 | 0.031 | 40 | 9.9 | 90 | 91 | 96 | 97 | 98 | 98 | 99 | 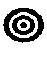 |
| Ex. 233 | 0.03 | 0.027 | 50 | 4.7 | 94 | 95 | 98 | 98 | 98 | 99 | 99 | ○ |
| Comp. ex. 219 | 0.04 | 0.062 | 0 | 105.6 | 62 | 70 | 77 | 80 | 80 | 81 | 81 | 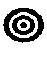 |
| Ref. ex. 221 | 0.04 | 0.061 | 5 | 99.9 | 61 | 70 | 76 | 79 | 80 | 80 | 81 | × |
| Ref. ex. 222 | 0.04 | 0.056 | 10 | 64.3 | 62 | 71 | 77 | 79 | 81 | 82 | 82 | × |
| Ex. 234 | 0.04 | 0.053 | 20 | 49.6 | 72 | 80 | 82 | 83 | 85 | 86 | 86 | Δ |
| Ex. 235 | 0.04 | 0.050 | 30 | 28.5 | 77 | 85 | 88 | 90 | 93 | 93 | 94 | ○ |
| Ex. 236 | 0.04 | 0.044 | 40 | 9.7 | 90 | 91 | 96 | 97 | 98 | 98 | 99 | 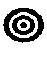 |
| Ex. 237 | 0.04 | 0.039 | 50 | 5.0 | 94 | 95 | 98 | 98 | 98 | 99 | 99 | 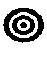 |

Having described our invention as related to the present embodiments, it is our intention that the invention not be limited by any of the details of the description, unless otherwise specified, but rather be construed broadly within its spirit and scope as set out in the accompanying claims.

This application claims priority on Patent Application No. 2010-136596 filed in Japan on June 15, 2010, Patent Application No. 2010-142664 filed in Japan on June 22, 2010, and Patent Application No. 2010-157132, filed in Japan on July 9, 2012, each of which is entirely herein incorporated by reference.

### REFERENCE SIGNS LIST

- 1: Substrate
- 2: Reflection layer (rolled layer)
- 3: Optical semiconductor element
- 4: Intermediate layer
- 5: Molding resin
- 6: Sealing resin
- 7: Bonding wire
- 8: Solderability-improving layer (Ag, Au, Sn, an alloy thereof, or the like)

## Claims

1. A lead frame for an optical semiconductor device, having a reflection layer at least on one side or each side of the outermost surface of a substrate, partially or entirely, wherein the reflection layer has, on the outermost surface at least in a region where light emitted by an optical semiconductor element is reflected, a microstructure with at least the surface thereof having been mechanically deformed, which is converted from a plating microstructure formed of a metal or an alloy thereof.

2. The lead frame for an optical semiconductor device according to claim 1, wherein the reflection layer has a surface roughness Ra of 0.010 µm or more measured with a contact needle-type surface roughness meter, and a surface roughness Sa of 50 nm or less measured with an atomic force microscope.

3. The lead frame for an optical semiconductor device according to claim 2, wherein the reflection layer is formed of any one of silver (Ag), gold (Au), copper (Cu), platinum (Pt), aluminum (Al), and rhodium (Rh), or an alloy thereof.

4. The lead frame for an optical semiconductor device according to claim 1, wherein the reflection layer is formed of silver, and at least at a surface thereof, an area ratio of the plating microstructure formed of silver that remains after mechanical deformation is 50% or less.

5. The lead frame for an optical semiconductor device according to any one of claims 1 to 4, wherein a thickness of the reflection layer mechanically deformed is 0.2 µm to 10 µm.

6. The lead frame for an optical semiconductor device according to claim 1 or 5, wherein the metal or the alloy thereof forming the reflection layer is silver, a silver-tin alloy, a silver-indium alloy, a silver-rhodium alloy, a silver-ruthenium alloy, a silver-gold alloy, a silver-palladium alloy, a silver-nickel alloy, a silver-selenium alloy, a silver-antimony alloy, or a silver-platinum alloy.

7. The lead frame for an optical semiconductor device according to any one of claims 1 to 6, wherein the substrate is composed of copper, a copper alloy, iron, an iron alloy, aluminum, or an aluminum alloy.

8. The lead frame for an optical semiconductor device according to any one of claims 1 to 7, wherein the substrate has n layers of metal layers thereon, in which n represents an integer of 1 or more, and wherein the reflection layer is provided on the substrate, directly, or with at least one layer of the metal layer interposed therebetween.

9. The lead frame for an optical semiconductor device according to any one of claims 1 to 8, having a plating layer formed of any one of silver, a silver alloy, tin, a tin alloy, gold, or a gold alloy, at least in an area where soldering is needed.

10. A method of producing a material of the lead frame for an optical semiconductor device according to any one of claims 1 to 8, comprising: forming the reflection layer formed of a metal or an alloy thereof, by a plating method, on the outermost surface of the substrate at least in the region where the light emitted by the optical semiconductor element is reflected; and subjecting to mechanical working, to mechanically deform the plating microstructure at least at the surface of the reflection layer.

11. The method of producing the material of the lead frame for an optical semiconductor device according to claim 10, wherein the mechanical working after formation of the reflection layer is carried out, by rolling with a working ratio at the time of rolling being adjusted to from 1% to 80%; or by pressing with a working ratio at the time of pressing being adjusted to from 1% to 80%; or by mechanical polishing.

12. A method of producing the lead frame for an optical semiconductor device according to any one of claims 1 to 8, comprising: forming the reflection layer formed of a metal or an alloy thereof, by a plating method, on the outermost surface of the substrate at least in the region where the light emitted by the optical semiconductor element is reflected; subjecting to mechanical working, to obtain the lead frame material for an optical semiconductor device having the plating microstructure at least at the surface of the reflection layer mechanically deformed; and subjecting the material to punching by a pressing method or an etching method, thereby to obtain the lead frame.

13. The method of producing the lead frame for an optical semiconductor device according to claim 12, wherein the mechanical working after the formation of the reflection layer is carried out, by rolling with a working ratio at the time of rolling being adjusted to from 1% to 80%; or by pressing with a working ratio at the time of pressing being adjusted to from 1% to 80%; or by mechanical polishing.

14. The method of producing the lead frame for an optical semiconductor device according to claim 12 or 13, comprising, after the punching, subjecting to plating to provide, partially thereon, a plating with a satisfactory soldering property.

15. The method of producing the lead frame for an optical semiconductor device according to claim 14, wherein the plating with a satisfactory soldering property is provided at least in a region other than the region where the light emitted by the optical semiconductor element is reflected, and wherein a component of the plating is any one of silver, a silver alloy, tin, a tin alloy, gold, or a gold alloy.

16. An optical semiconductor device, having: an optical semiconductor element; and the lead frame for an optical semiconductor device according to any one of claims 1 to 9, wherein the reflection layer of the lead frame for an optical semiconductor device is provided on the outermost surface of the substrate at least in the region where the light emitted from the optical semiconductor element is reflected, and the plating microstructure at least at the surface has a mechanically deformed microstructure.

17. The optical semiconductor device according to claim 16, wherein an emission wavelength of the optical semiconductor element is from 340 nm to 800 nm.

18. The optical semiconductor device according to claim 16 or 17, wherein the light emitted from the device is white light.

19. The optical semiconductor device according to claim 16 or 17, wherein the light emitted from the device is ultraviolet light, near-ultraviolet light, or violet light.

20. An illumination device, having the optical semiconductor device according to any one of claims 16 to 19.
